# EUROPÄISCHE PATENTANMELDUNG

(11) **EP 4 521 073 A1**
(43) Veröffentlichungstag der Anmeldung: **12.03.2025**
(21) Anmeldenummer: 23196556.7
(22) Anmeldetag: 11.09.2023
(51) Int. Cl.: G01F 1/684, G01F 5/00, G01F 15/18, B81B 7/00

(54) **STRÖMUNGSSENSOR PACKAGE**

(71) Anmelder: Hahn-Schickard-Gesellschaft für angewandte Forschung e. V., 70569 Stuttgart (DE)
(72) Erfinder: Dehé, Alfons, 72770 Reutlingen (DE); Billat, Sophie, 78052 VS-Weilersbach (DE)
(74) Vertreter: Hertin und Partner Rechts- und Patentanwälte PartG mbB

(57) **Zusammenfassung**

Die Erfindung betrifft ein Sensorpackage umfassend einen Sensorchip zur Messung mindestens eines Strömungsparameters eines Fluides, eine Bodenplatte und eine Abdeckung. Das Sensorpackage weist an der Abdeckung und/oder der Bodenplatte Öffnungen zur Bereitstellung eines Eintrittsbereiches und eines Austrittbereiches für das Fluid auf, sodass innerhalb des Sensorpackages ein Strömungskanal gebildet wird. Ferner weist der Sensorchip einen thermischen Sensor umfassend ein Heizelement zur Bereitstellung eines Wärmefeldes und eine Sensorkomponente zur Erfassung einer Temperaturantwort des thermischen Sensors in Abhängigkeit eines Einflusses des im Strömungskanal strömenden Fluides auf das Wärmefeld auf. Auf einer Außenseite des Sensorpackages wird mindestens eine Öffnung lateral von einem Dichtmaterial umschlossen.

Des Weiteren betrifft die Erfindung eine sensorpackageanordnung, ein System sowie eine Verwendung der Sensorpackageanordnung oder des Systems.

## Beschreibung

Die Erfindung liegt auf dem technologischen Gebiet der MEMS-Strömungssensorik. Die Erfindung betrifft ein Sensorpackage umfassend einen Sensorchip zur Messung mindestens eines Strömungsparameters eines Fluides, eine Bodenplatte und eine Abdeckung. Das Sensorpackage weist an der Abdeckung und/oder der Bodenplatte Öffnungen zur Bereitstellung eines Eintrittsbereiches und eines Austrittbereiches für das Fluid auf, sodass innerhalb des Sensorpackages ein Strömungskanal gebildet wird. Ferner weist der Sensorchip einen thermischen Sensor umfassend ein Heizelement zur Bereitstellung eines Wärmefeldes und eine Sensorkomponente zur Erfassung einer Temperaturantwort des thermischen Sensors in Abhängigkeit eines Einflusses des im Strömungskanal strömenden Fluides auf das Wärmefeld auf. Auf einer Außenseite des Sensorpackages wird mindestens eine Öffnung lateral von einem Dichtmaterial umschlossen.

Des Weiteren betrifft die Erfindung eine Sensorpackageanordnung, ein System sowie eine Verwendung der Sensorpackageanordnung oder des Systems.

### Hintergrund und Stand der Technik

Strömungssensoren werden in verschiedenen Anwendungen bei strömenden Fluiden verwandt und sind in der Lage, einen Strömungsparameter des Fluides zu messen. So kann beispielsweise die Geschwindigkeit, die Strömungsrichtung und/oder die Viskosität des Fluides mittels eines Strömungssensors erfasst werden, ohne hierbei auf die beispielhaft genannten Parameter beschränkt zu sein. Typischerweise wird der Einfluss der Strömung, d. h. der Einfluss, der durch die Bewegung des Fluides resultiert, für die Ausübung der Messung durch den Strömungssensor ausgenutzt.

In einigen Anwendungen ist es üblich, eine sogenannte Bypass-Konfiguration bereitzustellen, in der ein Strömungsparameter eines Fluides vermessen wird. Bei einer Bypass-Konfiguration wird ein Strömungsbegrenzer oder Durchflussbegrenzer innerhalb eines Hauptkanals eingebracht, in dem das Fluid strömt. Bei dem Hauptkanal kann es sich beispielsweise um eine Rohrleitung zum Transport einer Flüssigkeit oder innerhalb einer Industrieanlage handeln. Ferner wird ein Bypass (auch Bypass-Kanal oder Seitenkanal) mit dem Hauptkanal fluidisch verbunden. Durch den Durchflussbegrenzer resultiert ein Druckabfall, sodass im Hauptkanal in Abhängigkeit der Strömung des Fluides eine Druckdifferenz vorliegt. Bei entsprechender Anbindung des Bypasses an den Hauptkanal stromauf- und stromabwärts des Strömungsbegrenzers, wird das Fluid durch die Druckdifferenz in den Bypass geführt. Der Sensor, welcher zur Messung des Fluides eingesetzt wird, kann innerhalb oder angrenzend an den Bypass positioniert werden. Durch eine Bypass-Konfiguration kann eine zuverlässige Überführung des Fluides in hinreichender Nähe zum Sensor gewährleistet werden, ohne dass sich der Sensor im Hauptkanal befinden müsste und somit die Fluidströmung stören könnte. Zudem hängt die Fließgeschwindigkeit des Fluides im Bypass-Kanal unmittelbar von der Druckdifferenz ab, welche im Hauptkanal aufgrund des Durchfluss- oder Strömungsbegrenzers entsteht. Durch eine Messung der Fließgeschwindigkeit des Fluides im Bypass-Kanal kann somit ebenfalls eine Überwachung des Fließverhaltens des Fluides im Hauptkanal erfolgen.

Ein im Stand der Technik bewährtes Funktionsprinzip für den Betrieb von Strömungssensoren ist das thermische Messprinzip. Dabei umfasst der Strömungssensor zumeist ein Heizelement und mindestens einen Temperatursensor. Durch das Heizelement wird ein Wärmefeld bereitgestellt, das durch den Temperatursensor detektiert werden kann. Bei einer Strömung eines Fluides wird das von dem Heizelement bereitgestellte Wärmefeld moduliert. Die Modulation ist durch den Temperatursensor detektierbar, wobei die Modulation des Wärmefeldes von der Strömung des Fluides abhängig ist. Infolge der Modulation des Wärmefeldes lässt sich ein Strömungsparameter bestimmen. Das beschriebene Messprinzip ist dahingehend vorteilhaft, dass keine Bereitstellung von mechanisch beweglichen Komponenten erfolgen muss, sodass sich ein Herstellungsaufwand vermindert und hohe Robustheit erzielt werden kann.

Mittels sogenannter MEMS (mikroelektromechanische Systeme) können zudem thermische Strömungssensoren bereitgestellt werden, die eine sehr kompakte Ausgestaltung (im Mikrometerbereich) haben und eine hervorragende Funktionalität besitzen sowie mit geringen Herstellungskosten produziert werden können.

Bekannterweise benötigen MEMS zum Schutz und Einbindung in eine Applikation zumeist eine Plattform in Form eines Gehäuses. Man spricht hierbei auch vom Package oder Packaging des MEMS. Die konkrete Ausgestaltung des Packages hängt von derart des MEMS und von den Anforderungen ab, die es zu erfüllen gilt. Die Anforderungen hängen wiederrum mit dem konkreten Anwendungszweck zusammen.

In Lee, Ramados & Hoivik (2018) werden verschiedene Varianten für den strukturellen Aufbau von Packages für MEMS dargelegt. Packageaufbauten können grundsätzlich in keramische, metallische und Kunststoff-Packages unterschieden werden. Ein herkömmliches keramisches oder metallisches Package umfasst häufig eine Basis und eine Abdeckung bzw. Kappe. Auf der Basis ist das MEMS angebracht, welches zudem auf der Basis auch elektrisch kontaktiert werden kann, beispielsweise mittels Drahtbonds. Zur Verkapselung des MEMS wird die Abdeckung aufgebracht, welche das MEMS überdeckt und mit der Basis verbunden wird. Die Basis kann beispielsweise durch ein herkömmliches Halbleitersubstrat oder auch durch eine Leitungsplatte als Schaltungsträger. Die Abdeckung kann beispielsweise Glas, Metall, Keramik oder Kunststoff umfassend. Ob es sich bei dem Package um ein keramisches oder metallisches Package handelt, wird insbesondere durch die Materialauswahl des Packages bestimmt. Ein Kunststoffpackage basiert im Wesentlichen auf Kunststoff und kann einstückig oder mehrstückig ausgebildet sein. Kunststoffpackage lassen sich vor oder nach der Einbringung der MEMS effizient durch Urformverfahren geometrisch strukturieren, um eine gewünschte Form für das Package vorzugeben.

Auch für Strömungsensoren sind Packageaufbauten relevant. In Kuo, Yu & Meng (2012) wird eine Übersicht über Strömungssensoren und deren Packaging gegeben, welche auf einem thermisches Messprinzip beruhen.

Im Stand der Technik sind beispielsweise Polymersubstrate bekannt, die über flexible Eigenschaften verfügen und einen Abschnitt des Packages des Strömungssensors bilden. Dadurch können die Strömungssensoren auf gekrümmten Oberflächen aufgebracht werden und weisen weiterhin eine hinreichende Stabilität auf, um Strömungsmessungen vornehmen zu können. Insbesondere können solche Packages ebenfalls hohe Drücke von Strömungen erkennen. Auch in biologischen Kontexten können Polymersubstrate für ein Packaging von Strömungssensoren verwandt werden. So sind beispielsweise flexible Polymersubstrate bekannt, die auf Parylene C beruhen. Diese können für Strömungssensoren eingesetzt werden, um beispielsweise einen Blutfluss innerhalb einer Arterie zu messen. Das Polymersubstrat wird mit einem elektrisch leitfähigen Katheter verbunden und in den Wänden der Arterie implantiert, sodass auf Basis der Blutströmung medizinische Untersuchungen vorgenommen werden können.

Es sind auch Ansätze bekannt, die Strömungssensoren auf keramischen Substraten anzubringen. Diese eignen sich gut, um eine stabile Befestigung von Komponenten, wie z. B. Thermosäulen, Heizelement, Transistoren etc., zu ermöglichen. Der Strömungssensor kann auf dem keramischen Substrat angebracht werden, während am keramischen Substrat Kupfersäulenbumps verbunden sind. Kupfersäulenbumps (oder nur Kupferbumps) erfüllen neben einer elektrischen Funktionalität auch eine Wärmemanagementfunktion, sodass nachteilige parasitäre Wärmeeffekte, verringert werden können.

Weiterhin es ist es bekannt, beispielsweise zur Messung von Luftströmungen, ein Package derart auszugestalten, dass der eigentliche Strömungssensor auf einer dünnen Leiterplatte befestigt. Die Leiterplatte ist auf einer Trägerstruktur angebracht, die beispielsweise Aluminium umfasst, und erstreckt sich über eine Lücke an der Trägerstruktur. Die Trägerstruktur kann wiederum auf eine Halterung angebracht sein, welche durch Kunststoff gebildet wird. Die Luft, welche ausgemessen werden soll, strömt oberhalb des eigentlichen Sensors, d. h. oberhalb der Leiterplatte, auf welcher sich der Sensor befindet.

Ferner sind auch Ansätze für Strömungssensoren bekannt, bei der die Strömung eines Fluides gemessen werden, dass nicht direkt oberhalb bzw. an einer Sensorstruktur strömt. So kann beispielsweise eine Sensorstruktur auf einer Membran angebracht sein und die Strömung unterhalb der Membran erfolgen. Insbesondere kann hierbei durch das Package ein Strömungskanal bereitgestellt werden, in dem das Fluid eine Strömung ausführen kann. Der Strömungskanal verläuft innerhalb des Packages derart, dass die Strömung von dem Strömungssensor erfasst werden kann, um einen Rückschluss auf einen oder mehrere Strömungsparameter des Fluides zu ermöglichen.

In der WO 2021/078770 A1 wird beispielsweise ein Package offenbart, das einen Strömungskanal für die Strömung eines Fluides aufweist. Das Package umfasst mindestens zwei Substrate, welche miteinander verbunden vorliegen. Das erste Substrat kann durch ein Halbleitersubstrat bereitgestellt werden und umfasst eine Kavität. Das zweite Substrat formt im Wesentlichen den Strömungskanal. Bevorzugt liegt an dem zweiten Substrat ein Einlass und ein Auslass für das Fluid vor. Das zweite Substrat umfasst eine Formanpassung im Hinblick auf die Kavität des ersten Substrates und kann vorzugsweise durch einen vorgeformten Kunststoff gebildet werden. Ferner liegt ein thermischer Sensor auf einer dielektrischen Schicht vor, welche an die Kavität des ersten Substrates angrenzt. Eine elektrische Verbindung zum thermischen Sensor wird über Bumps ermöglicht, die zwischen der dielektrischen Schicht und einer Leiterplatte angebracht sind. In bevorzugten Ausführungsformen kann auch ein weiteres drittes Substrat bereitgestellt, welches insbesondere als vorgeformte Kunststoff bereitgestellt werden kann, und an dem zweiten Substrat zur Bereitstellung eines Ein- und Auslasses des Fluides angebracht werden kann. Nachteilig an der Verwendung von vorgeformten Kunststoffmaterialien sind Toleranzen in Bezug auf die Dimensionierung des Flusskanals, als auch deren verhältnismäßig hohen Kosten.

In Palmer et al. (2012) wird ein alternativer Ansatz vorgestellt, einen Strömungskanal für einen Strömungssensor bereitzustellen. Der darin beschriebene Strömungssensor umfasst einen Waferstack umfassend ein Bodensubstrat und ein Deckelsubstrat, welche in dem Fall jeweils durch einen Siliziumwafer bereitgestellt werden. Das Deckelsubstrat ist mit dem Bodensubstrat durch Fusionsbonden verbunden. Der Strömungssensor eignet sich vorteilhaft zur Integration in weiteren auf Silizium-basierten Vorrichtungen. Auf dem Deckelsubstrat liegt eine Membran vor, auf der drei oder fünf mäanderartige Strukturen aufgebracht vorliegen, um als mindestens ein Heizelement und als Temperatursensoren zu fungieren. Der Strömungskanal erstreckt sich innerhalb des Waferstacks entlang des Bodensubstrates und des Deckelsubstrates. Demzufolge kann ein Fluid über einen Eintrittsbereich innerhalb des Bodensubstrates in eine Kavität des Deckelsubstrates und über den Austrittsbereich am Bodensubstrat den Strömungskanal passieren. Für die Strömungsmessung liegt ein Interfacer vor, welcher durch zwei Leiterplatten gebildet wird, welche miteinander verbunden werden. Eine Sensorstruktur wird an den Interfacer verbunden, um die Strömungsmessung ausführen zu können.

Obwohl im Stand der Technik mehrere Ansätze bekannt sind, Packages für Strömungssensoren bereitzustellen, liegt diesbezüglich ein Bedarf an weiterer Optimierung vor. So sind bekannte Ansätze unter Verwendung von vorgeformten Plastiken kostenintensiv und können zu unerwünschten Toleranz führen, welche eine Kalibrierung und damit präzise Strömungsmessung erschweren. Die Bereitstellung eines Strömungskanals durch den Einsatz eines Interfacers hat sich ebenfalls als komplex, aufwendig und kostensensitiv erwiesen. Insbesondere hat es sich als schwierig erwiesen in dem Fall, eine einfache und zuverlässige fluidische Anbindung zum Package eines Strömungssensor zu bilden. Mithin besteht im Lichte des Standes der Technik ein Bedarf an verbesserten oder alternativen Packageaufbau für Strömungssensoren.

### Aufgabe der Erfindung

Aufgabe der Erfindung ist es, einen Sensorpackage bereitzustellen, durch den die Nachteile des Standes der Technik beseitigt werden. Insbesondere ist eine Aufgabe der Erfindung, einen Sensorpackage umfassend einen Sensorchip zur Messung mindestens eines Strömungsparameters eines Fluides bereitzustellen, welcher sich durch einen kompakten Aufbau auszeichnet, eine robuste Verbindung zu verschieden Applikationen ermöglicht und durch ein einfaches Herstellungsverfahren produzierbar ist.

### Zusammenfassung der Erfindung

Die Aufgabe der Erfindung wird gelöst durch die unabhängigen Ansprüche. Vorteilhafte Ausführungsformen der Erfindung sind in den abhängigen Ansprüchen beschrieben.

In einem ersten Aspekt betrifft die Erfindung ein Sensorpackage umfassend einen Sensorchip zur Messung mindestens eines Strömungsparameters eines Fluides, eine Bodenplatte und eine Abdeckung, wobei das Sensorpackage an der Abdeckung und/oder der Bodenplatte Öffnungen zur Bereitstellung eines Eintrittsbereiches und eines Austrittbereiches für das Fluid aufweist, sodass innerhalb des Sensorpackages ein Strömungskanal gebildet wird und wobei ferner der Sensorchip einen thermischen Sensor aufweist, umfassend ein Heizelement zur Bereitstellung eines Wärmefeldes und eine Sensorkomponente zur Erfassung einer Temperaturantwort des thermischen Sensors in Abhängigkeit eines Einflusses des im Strömungskanal strömenden Fluides auf das Wärmefeld, dadurch gekennzeichnet, dass mindestens eine Öffnung auf einer Außenseite des Sensorpackages lateral von einem Dichtmaterial umschlossen wird.

Vorteilhafterweise wird durch das Dichtmaterial auf einfache Weise eine stabile und fluiddichte Verbindung zwischen dem Sensorpackage und einer Anwendungskomponente, beispielsweise einer Hauptplatine und/oder einem fluidischen Anschluss ermöglicht. Insbesondere lässt sich das Dichtmaterial mit einfachen und mit im Stand der Technik bewährten Methoden anbringen, sodass es für einen Fachmann keinen hohen Aufwand bedarf, das erfindungsgemäßen Sensorpackage im Anwendungskontext zu integrieren.

Vorteilhaft ist hierbei zudem der Umstand, dass das Dichtmaterial mehrere Funktionen erfüllen kann. So kann beispielsweise neben einer mechanischen Fixierung und einem fluidischen Abschluss insbesondere zudem eine elektrische Kontaktierungsmöglichkeit geboten werden, indem für das Dichtmaterial ein elektrisch leitfähiges Material gewählt wird. Mithin ermöglicht das Dichtmaterial nicht nur eine einfache, mechanische stabile und fluiddichte Verbindung an eine Hauptströmungskanal, dessen Fluid auszumessen ist, sondern kann gleichzeitig eine elektrische Anbindung der im Sensorpackage enthaltenen elektronischen Komponenten, wie einem thermischen Sensor und/oder eine elektronische Schaltung mit einem externen Schaltungsträger, beispielsweise eine Hauptplatine, gewährleisten.

Weiterhin kann durch das Dichtmaterial, insbesondere sofern ein elastisches Material umfasst ist, zusätzlich eine Federung bewirkt werden. Beispielsweise kann dies bei starken Strömungen des Fluides von Vorteil sein, um eine Dämpfung zu erzielen.

Auf dem Gebiet der MEMS-Mikrofone ist es bekannt, einen Lötring für eine sogenannte Bottom-Port Konfiguration für MEMS-Mikrofone auf einer Leiterplatte zu befestigen. Der Lötring kann einen Bereich umschließen, der an der Schalleintrittsöffnung für MEMS-Mikrofone angebracht ist und soll insbesondere für einen akustischen Abschluss dienen. Erfindungsgemäß wurde erkannt, dass ein zumindest in Teilen ähnliches Konzept einen vereinfachten Anschluss von Strömungssensoren an die jeweilige Anwendung ermöglicht.

Dies war keineswegs naheliegend, da sich Strömungssensoren und MEMS-Mikrofone in ihrem Verwendungszweck und ihrem strukturellen Aufbau unterscheiden und der Lötring der MEMS-Mikrofone insbesondere einem akustischen Abschluss dient. Die Anbringung eines Dichtmaterials, welches lateral und außenseitig eine Öffnung, eines Sensorpackages zur thermischen Messung von Strömungen vorsieht, stellt für das technologische Gebiet der Strömungssensoren hingegen eine Abkehr von bekannten Ansätzen und wesentliche Vereinfachung eines Packaging dar.

Im Sinne der Erfindung bezeichnet das Sensorpackage bevorzugt eine Kombination, welche durch den Sensorchip, die Abdeckung und die Bodenplatte gebildet wird. Mithin umfasst im Kontext der Erfindung das Sensorpackage bevorzugt sowohl eine gehäuseartige Komponente, welche insbesondere durch die Bodenplatte und die Abdeckung gebildet wird, sowie sensorische Komponenten, wie sie durch den Sensorchip bereitgestellt werden und innerhalb des gehäuseartige Komponenten vorliegen. Das Package als Gehäuse wird bevorzugt durch die Bodenplatte und die Abdeckung gebildet.

Der Sensorchip dient insbesondere der Messung mindestens eines Strömungsparameters eines Fluides. Demzufolge kann der Sensorchip im erfindungsgemäßen Kontext auch als Strömungssensor bezeichnet werden. Das Fluid bezeichnet bevorzugt ein Medium, welches insbesondere durch den Strömungskanal fließen kann von dem mindestens ein Strömungsparameter mittels des Sensorchips gemessen werden soll. Das Fluid selbst meint bevorzugt ein Medium, welches sich unter Einfluss von Scherkräften kontinuierlich verformen kann. Insbesondere kann das Fluid als eine Flüssigkeit oder als ein Gas vorliegen.

Der mindestens eine Strömungsparameter bezeichnet eine Größe, mit der das Fluid in seinen physikalischen und/oder chemischen Eigenschaften charakterisiert werden kann. Vorzugsweise kann der Strömungsparameter ausgewählt sein aus einer Gruppe umfassend eine Strömungsgeschwindigkeit, ein Druck, ein Volumenstrom, eine Strömungsfrequenz (bei einer oszillierenden Strömung des Fluides), eine Konzentration und/oder Zusammensetzung des Fluides, ohne auf diese bevorzugten Parameter beschränkt zu sein.

Der Sensorchip umfasst einen thermischen Sensor, mit welchem die Erfassung der Strömung durch den Strömungskanal ermöglicht wird. Der thermische Sensor weist vorzugsweise ein Heizelement auf, das der Bereitstellung des Wärmefeldes dient sowie eine Sensorkomponente, mit der eine Temperaturantwort erfasst wird. Durch die Sensorkomponente wird insbesondere der Einfluss des Fluides auf das Wärmefeld innerhalb des Strömungskanals erfasst. Der Sensorchip weist bevorzugt eine Membran auf, auf welcher der thermische Sensor angebracht ist. Insbesondere kann der Sensorchip bevorzugt eine Trägerstruktur umfassen, welche eine Kavität aufweist, auf der sich die Membran erstreckt und vorzugsweise auf der der thermische Sensor positioniert ist.

Der Sensorchip kann für verschiedene thermische Messprinzipen ausgelegt sein und/oder bevorzugt dazu konfiguriert sein, vorzugsweise unter Einsatz einer elektronischen Schaltung, in einer oder verschiedenen Moden betrieben zu werden, um eine Messung von mindestens einem Strömungsparameter vorzunehmen.

Beispielsweise kann der Sensorchip ein anemometrisches Messprinzip nutzen, bei dem ein Heizelement vorzugsweise auf einer Membran aufgebracht oder in einer Membran eingebettet vorliegt und die Fluidströmung anhand eines Wärmetransportes in bzw. durch das Fluid gemessen wird, welches sich mit der Strömungsgeschwindigkeit ändert. So kann es bevorzugt sein, dass das Heizelement mit einer konstanten Leistung eingespeist oder auf eine konstante Temperatur gehalten wird. Durch die Strömung des Fluides innerhalb des Wärmefeldes ergibt sich durch Konvektion bzw. Wärmetransport eine Temperaturabnahme, wenn eine konstante Leistung eingespeist wurde oder es resultiert eine notwendige Erhöhung der für das Heizelement zugeführten Leistung, wenn eine Temperatur des Heizelementes konstant gehalten werden soll. Die Konvektion ist proportional zur Flussrate des Fluides, sodass durch die Temperaturabnahme oder durch die Erhöhung der Leistung zur Beibehaltung der Temperatur beispielsweise die Strömungsgeschwindigkeit des Fluides bestimmt werden kann. Vorzugsweise kann die Sensorkomponente durch das Heizelement selbst gebildet werden, welche beispielsweise anhand eines temperaturabhängigen Widerstandes eine strömungsabhängige Temperaturabnahme bestimmen kann.

Es kann ebenfalls bevorzugt sein, dass der Sensorchip für ein kalorimetrisches Messprinzip ausgelegt ist. Bei einem kalorimetrischen Messprinzip wird vorzugsweise ausgenutzt, dass sich das Temperaturprofil um das Heizelement aufgrund der Konvektion durch die Strömung des Fluides ändert. Vorzugswird werden ein, bevorzugt zwei Temperatursensoren, stromabwärts und stromaufwärts des Heizelementes positioniert. In Abhängigkeit der Strömung des Fluides wird eine stromabwärts und stromaufwärts vom Heizelement gemessene Temperatur unterschiedlich sein. Durch eine Messung der Temperarturdifferenz kann ein Rückschluss auf einen Strömungsparameter des Fluides ermöglicht werden. Das Heizelement kann mit einer konstanten Spannung, einem konstantem Strom, einer konstanter Leistung oder auf eine konstante Temperatur beheizt werden.

Ferner kann es bevorzugt sein, den Sensorchip für einen sogenannten Time-of-Flight (TOF)-Messprinzip auszulegen. Dabei wird bevorzugt die Zeit zwischen dem Moment, in dem ein Ansteuerungssignal durch das Heizelement geleitet wird und dem Zeitpunkt, an dem ein maximaler Temperaturanstieg an einer Sensorkomponente, beispielsweise einem Temperatursensor, in einem bekannten Abstand zum Heizelement gemessen wird. Je höher die Durchflussrate ist, desto kürzer ist die sogenannte TOF.

Durch den Sensorchip, insbesondere der Temperaturantwort des thermischen Sensor, kann bevorzugt weitere Eigenschaften des Fluides bestimmt werden, wie beispielsweise eine Wärmeleitfähigkeit, eine Dichte, einen Druck, eine spezifische Wärmekapazität, eine Wärmeleitfähigkeit, eine Konzentration und/oder eine Zusammensetzung des Fluides.

Dem Fachmann ist bekannt, dass beispielsweise mittels einer oszillierenden Ansteuerung eine frequenzabhängige Temperaturantwort beispielsweise genutzt werden kann, um einen Rückschluss auf eine Wärmeleitfähigkeit und/oder volumetrischen Wärmekapazität eine Fluides zu erhalten. So kann beispielsweise eine Bestimmung einer Phase zwischen einem oszillierenden Ansteuerungssignal und eine Temperaturantwort insbesondere genutzt werden, um eine Wärmeleitfähigkeit zu bestimmen. Eine Amplitude einer Temperaturantwort bei oszillierende Ansteuerung kann insbesondere neben der Wärmeleitfähigkeit auch von einer volumetrischen Wärmekapazität abhängen. Mithin kann über eine Phase und Amplitude einer Temperaturantwort gegenüber einer oszillierenden Ansteuerung beispielsweise eine Wärmeleitfähigkeit und/oder volumetrische Wärmekapazität des Fluides werden. Anhand dieser thermischen Parameter lassen sich weiterhin auch Rückschlüsse beispielsweise auf eine Zusammensetzung des Fluides und/oder Konzentration einer Komponente innerhalb eines Mischfluides schließen. Sind beispielsweise eine Wärmeleitfähigkeit und/oder volumetrische Wärmekapazität verschiedene Komponente eines Mischfluides, z.B. eines Mischgases bekannt, lassen sich anhand einer Bestimmung der Wärmeleitfähigkeit und/oder volumetrische Wärmekapazität des gesamten Fluides Rückschlüsse auf die Anteile der einzelnen Komponenten ziehen.

Der Sensorchip liegt bevorzugt auf der Bodenplatte angebracht vor. Mithin fungiert die Bodenplatte als ein Träger für den Sensorchip, der innerhalb des Sensorpackages eingebracht ist. Die Abdeckung ist bevorzugt mit der Bodenplatte verbunden. Die Bodenplatte und die Abdeckung bilden vorzugsweise zusammen eine Ummantelung bzw. Gehäuse, welches den Sensorchip bis auf vorgesehene Eintritt- und Austrittsbereiche des Fluides den Sensorchip vollständig abschirmt. Das Package umfassend die Bodenplatte und Abdeckung erfüllt vorzugsweise eine Trägerfunktion und eine Schutzfunktion. Während die Bodenplatte als Träger des Sensorchips eine Trägerfunktion erfüllt und Schutzwirkung entlang einer Unterseite bewirkt, wird eine Schutzfunktion entlang einer Oberseite durch die Abdeckung erzielt.

Der Eintrittsbereich stellt einen Übergangsbereich dar, über den das Fluid von einer Umgebung des Packages in den Strömungskanal hineingelangt. Entsprechend stellt der Austrittsbereich einen Übergangsabschnitt des Strömungskanals dar, durch den das Fluid den Strömungskanal verlassen kann. Mithin ist es bei einer Messung des mindestens einen Strömungsparameters durch den Sensorchip bevorzugt, dass das Fluid ausgehend von dem Eintrittsbereich in den Strömungskanal hineinströmt und ausgehend von dem Austrittsbereich den Strömungskanal verlässt.

Der thermische Sensor umfasst insbesondere ein Heizelement und eine Sensorkomponente. Das Heizelement dient insbesondere der Bereitstellung eines Wärmefeldes. Das Wärmefeld bezeichnet die Wärme als solche, die von dem Heizelement ausgeht und sich innerhalb des Strömungskanals ausbreiten und vom Fluid durchströmt werden kann. Die Begriffe Wärmefeld und Wärmestrom können im erfindungsgemäßen Kontext synonym verwandt werden.

Vorzugsweise beeinflusst das Fluid durch seine Strömung innerhalb des Strömungskanals das Wärmefeld. Dieser Einfluss und die damit einhergehende Änderung des Wärmefeldes ist durch die Sensorkomponente des thermischen Sensors erkennbar. Die Änderung des Wärmefeldes durch die Strömung des Fluides kann auch als Modulation des Wärmefeldes bezeichnet werden. Der Einfluss des Fluides auf das Wärmefeld bzw. die Modulation spiegelt sich insbesondere in der Temperaturantwort wider, die von der Sensorkomponente des thermischen Sensors erfasst wird. Mit anderen Worten ausgedrückt, dient die Sensorkomponente dazu, eine Temperaturantwort zu erfassen, die wiederrum abhängig ist von der Modulation des Wärmefeldes durch das Fluid.

Die Temperaturantwort meint bevorzugt ein Messsignal, das von der Sensorkomponente erfasst wird. Die Temperaturantwort stellt somit bevorzugt eine Reaktion des thermischen Sensors, insbesondere der Sensorkomponente, in Bezug auf die Eigenschaften bzw. die Strömung des Fluides hinsichtlich seiner Wirkung auf das Wärmefeld dar. Die Sensorkomponente kann vorzugsweise als ein Temperatursensor vorliegen, sodass bevorzugt die Temperaturantwort von dem Temperatursensor erfasst wird. Es kann ebenfalls bevorzugt sein, dass die Sensorkomponente durch das Heizelement selbst bereitgestellt wird, sodass bevorzugt die Temperaturantwort ein Messsignal des Heizelementes darstellt, welches durch die Strömung des Fluides beeinflusst wird. Die Temperaturantwort kann bevorzugt eine thermische Größe betreffen, welche insbesondere von der Sensorkomponente ausgelesen werden kann, wie z. B. die Temperatur selbst. Die Temperaturantwort kann vorzugsweise auch ein elektrisches Signal meinen, das bevorzugt durch eine elektrische Spannung und/oder einen elektrischen Strom beschrieben werden kann.

Innerhalb des Sensorpackage ist ein Strömungskanal eingebracht. Der Strömungskanal gibt insbesondere einen Pfad vor, durch den das zu vermessende Fluid strömen kann. Ferner gelangt durch den Strömungskanal das Fluid in eine hinreichende Nähe zum thermischen Sensor, sodass eine Einflussnahme des Fluides auf das vom Heizelement bereitgestellte Wärmefeld möglich ist. Mit anderen Worten wird durch den Strömungskanal eine Strecke für die Strömung des Fluides bereitgestellt, durch den das Fluid sich ausbreiten kann, um von dem thermischen Sensor vermessen zu werden. Der Verlauf der Strömung, um die Einflussnahme am Wärmefeld des Heizelementes vorzunehmen, kann durch den Strömungskanal vorgegeben werden. Der Strömungskanal umfasst insbesondere den Eintrittsbereich, den Austrittsbereich und einen dazwischenliegenden Raumbereich.

So kann beispielsweise ausgenutzt werden, dass infolge der Fluidströmung ein Wärmetransport durch die Sensorkomponente festgestellt werden kann, wobei sich der Wärmetransport mit der Strömungsgeschwindigkeit ändert. So kann es bevorzugt sein, dass das Heizelement mit einer konstanten Leistung eingespeist oder auf eine konstante Temperatur gehalten wird. Durch die Strömung des Fluides innerhalb des Wärmefeldes ergibt sich durch Konvektion bzw. Wärmetransport eine Temperaturabnahme, wenn eine konstante Leistung eingespeist wurde oder es resultiert eine notwendige Erhöhung der für das Heizelement zugeführten Leistung, wenn eine Temperatur des Heizelementes konstant gehalten werden soll. Die Konvektion ist proportional zur Flussrate des Fluides, sodass durch die Temperaturabnahme oder durch die Erhöhung der Leistung zur Beibehaltung der Temperatur beispielsweise die Strömungsgeschwindigkeit des Fluides bestimmt werden kann.

Der Eintrittsbereich und der Austrittsbereich werden durch Öffnungen am Sensorpackage gebildet. Eine Öffnung bezeichnet bevorzugt einen Aussparung im Sensorpackage, beispielsweise in der Bodenplatte und/oder Abdeckung, durch welche die Öffnung das Fluid hinein- und/der hinausgelangen kann. In bevorzugten Ausführungsformen befinden sich die Öffnungen zur Bereitstellung des Eintrittsbereiches und des Austrittsbereiches an der Bodenplatte. In bevorzugten Ausführungen befinden sich die Öffnungen zur Bereitstellung des Eintrittsbereiches und des Austrittsbereiches in der Abdeckung. Es kann ebenfalls bevorzugt sein, dass sich die Öffnungen zur Bereitstellung des Eintrittsbereiches oder des Austrittsbereiches jeweils an der Bodenplatte oder Abdeckung befinden.

Mindestens eine der Öffnungen wird auf der Außenseite des Sensorpackages von dem Dichtmaterial lateral umschlossen. Vorzugsweise werden insbesondere jene Öffnungen auf der Außenseite des Sensorpackages lateral von einem Dichtmaterial umschlossen, welche eine Verbindung mit einer Anwendung, beispielsweise eine Hauptplatine und/oder einem fluidischen Anschluss ermöglichen soll. Die Außenseite des Sensorpackages meint bevorzugt jene Seite, des Sensorpackages welche von einem Innenraum des Sensorpackages abgewandt ist und in dem der Sensorchip eingebracht vorliegt.

Dass das Dichtmaterial die mindestens eine Öffnung lateral umschließt, meint bevorzugt, dass das Dichtmaterial entlang der mindestens einen Öffnung eine in sich geschlossene Ausgestaltung aufweist. Das kann beispielsweis bedeuten, dass das Dichtmaterial lateral um die mindestens eine Öffnung herum auf der Außenseite ellipsenförmig, bevorzugt ringförmig strukturiert ist. Auch andere in sich geschlossene Formen können bevorzugt sein, beispielsweise dreieckig, viereckig, fünfeckig, sechseckig oder anderweitig mehreckig gebildete Konturen.

Das laterale Umschließen soll bevorzugt zum Ausdruck bringen, dass das Dichtmaterial auf der Außenseite des Sensorpackage aufgebracht die mindestens eine Öffnung vollständig umschließt, ohne die Öffnung zu verdecken. Vorzugsweise umrandet das Dichtmaterial die mindestens eine Öffnung auf der Außenseite des Sensorpackages. Mithin erstreckt sich das Dichtmaterial entlang der Außenseite, ohne dass es in die Öffnung selbst hineingelangt, sodass Turbulenzen an den Übergangsbereichen verringert oder vermieden werden.

Das eine lateral umschließende Dichtmaterial ist bevorzugt im Wesentlichen flächig ausgestaltet. Eine flächige Ausgestaltung meint bevorzugt, dass das Dichtmaterial einen Umfang umfasst, der um ein Vielfaches höher ist als eine Dicke bzw. Höhe des Dichtmaterials, beispielsweise um einen Faktor 1,5, 2, 3, 4, 5, 6, 7, 8, 9, 10 oder mehr. Eine Dicke bzw. Höhe des Dichtmaterials meint bevorzugt den Vorstand bzw. Ausdehnung des Dichtmaterials gemessen von einer Außenseite des Sensorpackages, z.B. einer Bodenplatte und/oder Abdeckung, nach außen. Eine Länge bzw. Umfang bezeichnet bevorzugt die Ausdehnung entlang der geschlossenen Form des Dichtmaterials, während eine Breite orthogonal zur Höhe bzw. Dicke des Dichtmaterials.

Im Falle einer Ringform bezeichnet die Breite beispielsweise eine Differenz zwischen einem inneren und äußeren Radius. Das Dichtmaterial kann bevorzugt eine Dicke von 0,1 - 10 mm (Millimeter), bevorzugt von 0,5 - 5 mm aufweisen und/oder eine Breite von 0,1 - 3 mm, bevorzugt von 0,2 - 2. Die genannten bevorzugten Bereiche für eine Dicke und/oder eine Breite haben sich als vorteilhaft erwiesen, einen zuverlässigen fluidischen Anschluss zu gewährleisten. Vorzugsweise entspricht der Umfang des Dichtmaterials im Wesentlichen dem Umfang des Eintrittsbereiches und des Austrittsbereiches, da das Dichtmaterial diese Bereiche lateral umschließt. Mithin ist die Dimensionierung des Umfanges des Dichtmaterials vorzugsweise abhängig von dem Umfang des Eintrittsbereiches und des Austrittsbereiches.

In einer weiteren bevorzugten Ausführungsform ist das Sensorpackage dadurch gekennzeichnet, dass das Dichtmaterial ringförmig die mindestens eine Öffnung lateral umschließt und einen Dichtring bildet.

Eine ringförmige Ausgestaltung des Dichtmaterials meint bevorzugt eine im Wesentlichen kreisförmige Ausgestaltung des Dichtmaterials. Ein Länge bezeichnet hierbei bevorzugt die Ausdehnung des Dichtmaterials entlang eines (mittleren) Umfang des Dichtring bzw. Kreises. Eine Breite des Dichtrings kann bevorzugt durch die Differenz zweier konzentrischen Kreises gebildet werden, d. h. einem inneren Kreis (entlang des inneren Umfangs des Dichtrings) und einem äußeren inneren Kreis (entlang des inneren Umfangs des Dichtrings). Eine ringförmige Ausgestaltung des Dichtmaterials kann im erfindungsgemäßen Kontext auch als Dichtring bezeichnet werden.

Vorteilhaft ist ein Dichtring besonders einfach anzubringen und eignet sich insbesondere für kreisförmige Öffnungen, welche einen Eintrittsbereich und/oder Austrittsbereich bilden. Mithin wird vorzugsweise durch einen Dichtring sichergestellt, dass dieser eine kreisförmige Öffnung lateral umschließt, d. h. auf der Außenseite umgrenzt und sich damit vorteilhaft für eine zuverlässige Befestigung eignet.

In einer weiteren bevorzugten Ausführungsform ist das Sensorpackage dadurch gekennzeichnet, dass das Dichtmaterial ein Lotmaterial, ein Bondmaterial, einen Klebstoff und/oder einen Kunststoff, vorzugsweise ein Elastomer umfasst.

Ein Bondmaterial bezeichnet bevorzugt ein Material, welches beim Bonden eingesetzt wird. Bonden. Das Bonden beschreibt bevorzugt einen Verfahrensschritt in der Halbleiter- und/oder Mikrosystemtechnik, bei dem ein Substrat mit einem weiteren Substrat und/oder eine weitere Komponente verbunden werden kann. Dazu ist es bevorzugt, das entsprechende Bondmaterial einzusetzen, das für das jeweilige Bondverfahren benötigt wird, um die Verbindung bereitstellen zu können. Das Bondmaterial kann beispielsweise auf das Sensorpackage oder auf eine weitere Anwendung aufgebracht werden, beispielsweise eine Hauptplatine. Daraufhin wird der Bondprozess ausgeführt, um eine Bondverbindung zwischen dem Sensorpackage und der weiteren Anwendung zu bilden. Beim Bonden können vorzugsweise verschiedene Verfahren zum Einsatz kommen. Diese werden auch als Bondprozesse oder Bondverfahren bezeichnet. Bevorzugte Bondprozesse umfassen direktes Bonden, anodisches Bonden, Bondverfahren mit Zwischenschichten, Glas-Frit-Bonden, adhäsives Bonden und/oder selektives Bonden, für die die entsprechenden Bondmaterialien benötigt werden.

Ein Klebstoff meint bevorzugt einen Stoff, mit dem ein Verkleben ermöglicht wird. Vorteilhaft kann eine lateral umschlossene Form des Klebstoffes an der Öffnung bereitgestellt werden, ohne Wärme und/oder Druck anwenden zu müssen. Stattdessen erstarrt der Klebstoff nach einem Zeitintervall, sodass der Klebstoff als eine in sich geschlossene Form auf der Außenseite um die mindestens eine Öffnung herum übrigbleibt. Beim Einsatz eines Klebstoffes reicht vorteilhaft die Ausübung eines mechanischen Druckes aus, um eine Verbindung des Sensorpackages an eine weitere Anwendung, wie z. B. der Bodenplatte, zu ermöglichen. Insbesondere ist es zwangsläufig nicht notwendig, eine externe Wärme- und/oder Druckzufuhr vorzugeben.

Es kann ebenfalls bevorzugt sein, den Dichtmaterial durch einen Kunststoff bereitzustellen. Bevorzugt kann der Kunststoff als ein Elastomer vorliegen. Ein Elastomer bezeichnet einen formfesten Kunststoff, der jedoch zusätzlich verformbar ist, insbesondere einen Glasübergangspunkt aufweist, der sich unterhalb der Raumtemperatur befindet. Bevorzugt kann ein Dichtring eingesetzt werden, der einen Kunststoff umfasst, insbesondere ein Elastomer, der beispielsweise Gummi umfasst, d. h. ein Dichtring im Sinne eine Dichtungsringes für hydraulische Anwendungen. Der Dichtring wird bevorzugt auf einer Umrandung des Eintrittsbereiches und/oder Austrittsbereiches auf der Außenseite des Sensorpackages aufgebracht. Hierbei wird vorteilhaft eine mechanische Verbindung zwischen dem Sensorpackage und einer externen Anwendung, insbesondere der Bodenplatte, durch eine Druckwirkung des Dichtrings erzielt. Auch ein hoher mechanischer Druck von außen muss vorteilhaft nicht zwangsläufig aufgebracht werden, um eine feste Verbindung zu erzielen.

In einer weiteren bevorzugten Ausführungsform ist das Sensorpackage dadurch gekennzeichnet, dass durch das Dichtmaterial eine elektrische Verbindung vorliegt, die für einen elektrischen Anschluss verwendbar ist.

Vorteilhafterweise wird hierbei neben einer stabilen mechanischen Verbindung auch eine robuste und elektrische Verbindung durch den Einsatz des Dichtmaterials erzielt. Die Bereitstellung einer elektrischen Verbindung durch das Dichtmaterial liegt insbesondere dann vor, wenn das Dichtmaterial ein elektrisch leitfähiges Material umfasst. Bevorzugt ist dies bei der Verwendung eines Lötmaterials bzw. als Dichtmaterial zur Bildung eines Lötrings der Fall.

Somit kann vorteilhafterweise das Dichtmaterial eine mechanische Verbindung, einen fluidischen Abschluss und zusätzliche eine elektrische Verbindung bereitstellen.

In einer weiteren bevorzugten Ausführungsform ist das Sensorpackage dadurch gekennzeichnet, dass das Dichtmaterial ein Lotmaterial umfasst, welches als Lötring vorliegt, wobei bevorzugt das Lotmaterial ein Material umfasst, ausgewählt aus einer Gruppe umfassend Zinn, Zink, Kupfer, Silber, Gold, deren Verbindungen und/oder Legierungen.

Ein Lotmaterial bezeichnet bevorzugt ein Material, welches insbesondere beim Löten eingesetzt wird. Durch das Schmelzen des Lotmaterials kann dieses derart strukturiert werden, dass es eine Öffnung auf der Außenseite des Sensorpackages lateral umschließen kann, d. h. eine in sich geschlossene Form aufweist. Für die Strukturierung des Lotmaterials wird bevorzugt eine Temperatur aufgebracht, die im Wesentlichen der Schmelztemperatur entspricht oder höher als die Schmelztemperatur ist. Durch eine Aufbringung einer entsprechenden Schmelztemperatur kann das Lotmaterial auf der Außenseite des Sensorpackages sich an den Eintrittsbereich und Austrittsbereich anpassen, sodass das Lotmaterial einen geschlossenen Ring (Lötring) bilden kann. Über das Lotmaterial kann kurz nach der Ausbildung des Lötrings im geschmolzenen Zustand eine feste und robuste Verbindung zu einer externen Anwendung, z.B. einer Hauptplatine, ermöglicht werden.

Ein Lötring bezeichnet vorzugsweise eine ringförmiges Lotmaterial, das auf der Außenseite des Sensorpackages für ein Umschließen mindestens einer Öffnung aufgebracht vorliegt. Der Einsatz eines Lötrings für das Dichtmaterial hat sich als besonders vorteilhaft erwiesen. Neben einem sicheren und langanhaltenden festen Verbindung auf der Außenseite kann der Lötring auch dazu verwandt werden, elektrische Funktionen zu erfüllen, beispielsweise zur Stromversorgung und/oder zur Übertragung von (Mess-)signalen. Des Weiteren ist es von Vorteil, dass die Ausgestaltung des Lötrings einfach vorzunehmen ist, sodass eine erhebliche Prozesseffizienz im Hinblick auf die Anbringung des Dichtmaterials erzielt wird, das lateral auf der Außenseite die mindestens eine Öffnung umschließen soll.

Die genannten bevorzugten Materialien zur Bildung des Lötrings sind dahingehend von besonderem Vorteil, dass sie vorzugsweise eine Schmelztemperatur haben, welche geringer ist als eine kritische Temperatur für den Sensorpackage oder für temperaturempfindliche Komponenten des Sensorpackages, sodass eine zuverlässige Anbringung des Lötrings ermöglicht werden kann. Des Weiteren sind die aufgezählten Materialien für die Bereitstellung des Lötrings kostengünstig zu erwerben und können beim Löten, insbesondere im erfindungsgemäßen Sensorpackage, einfach implementiert werden, um die mindestens eine Öffnung lateral auf der Außenseite zu umschließen.

In einer weiteren bevorzugten Ausführungsform ist das Sensorpackage dadurch gekennzeichnet, dass die Bodenplatte als ein Halbleitersubstrat oder als ein Schaltungsträger, vorzugsweise als eine Leiterplatte vorliegt.

Ein Halbleitersubstrat bezeichnet bevorzugt eine runde oder eckige Scheibe, die eine Dicke im Millimeter- oder Submillimeterbereich aufweist. Halbleitersubstrate können synonym auch als Wafer bezeichnet werden. Das Halbleitersubtrat bezeichnet vorzugsweise eine zu bearbeitenden Komponente und/oder eine Komponente, die der Platzierung des Sensorchips dient. Halbleitersubstrate werden typischerweise aus ein- oder polykristallinen (Halbleiter-)Rohlingen, sogenannten Ingots, hergestellt.

Halbleitersubstrate sind in der Halbleiter- und/oder Mikrosystemtechnik besonders einfach und kostengünstig zu bearbeiten und eignen sich ebenfalls gut für eine Massenherstellung. Ebenso sind diese Materialien für ein Dotieren und/oder ein Beschichten besonders geeignet, um in bestimmten Bereichen die gewünschten mechanischen, elektrischen, thermischen und/oder optischen Eigenschaften zu erzielen.

Ein Schaltungsträger bezeichnet bevorzugt ein Bauelement umfassend ein elektrisch isolierendes Material, auf dem elektrisch leitende Verbindungen (Leiterbahnen) und/oder elektronische Bauelemente bzw. Baugruppen vorliegen. Ein Schaltungsträger bezeichnet mithin vorzugsweise einen Träger für elektronische Bauteile oder elektrisch leitende Verbindungen, der sowohl der mechanischen Befestigung als auch der elektrischen Verbindung dient.

Auf oder in dem Schaltungsträger liegen vorzugsweise elektronische Komponente sowie elektrische Verbindungen vor, die beispielsweise durch Drahtbonds Leiterbahnen und/oder Leiterbahnstreifen eine elektronische Verbindung ermöglichen. Mithin fungiert der Schaltungsträger sowohl als mechanischer Träger als auch für eine elektrische Verbindung zur Realisierung von elektrischen Funktionen. Die elektrischen Verbindungen des Schaltungsträgers dienen insbesondere der elektrischen Kontaktierung von Komponenten. Das isolierende Material des Schaltungsträgers gibt bevorzugt eine Grundform des Schaltungsträgers vor, insbesondere um einen mechanischen Kontakt mit dem Sensorchip vorzugeben. Durch das Dichtmaterial kann insbesondere eine mechanische Verbindung mit dem Schaltungsträger vorgegeben werden. Weiterhin kann durch das Dichtmaterial, insbesondere wenn es ein elektrisch leitfähiges Material umfasst, (z.B. als Lötring), eine elektrische Verbindung zwischen dem Schaltungsträger und dem Sensorchip ermöglichen.

Es kann ebenfalls bevorzugt sein, dass auf dem Schaltungsträger eine elektronische Schaltung eingebracht vorliegt, welche für die Messung des mindestens einen Strömungsparameters elektrische Signale senden, empfangen und/oder verarbeiten kann.

Bevorzugt wird als Schaltungsträger eine Leiterplatte eingesetzt. Eine Leiterplatte bezeichnet bevorzugt eine bestimmte Art eines Schaltungsträgers, welcher elektrische Verbindungen umfasst und eine mechanische Stütze für oberflächenmontierte und/oder gesockelte Komponenten bietet. Vorzugsweise umfasst eine Leiterplatte als isolierendes Material Fiberglas, ein Epoxid und/oder einen anderen Verbundwerkstoff.

Eine Leiterplatte ist dahingehend vorteilhaft, dass besonders einfach zwei Öffnungen bereitgestellt werden können, die mit dem Eintrittsbereich und dem Austrittsbereich des Strömungskanals am Sensorchip korrespondieren. Ferner zeichnen sie sich eine Leiterplatte durch eine hohe Stabilität aus, sodass auch die Messung von Strömungen mit einem hohen hydrodynamischen Druck mittels der Strömungssensoranordnung weiterhin genau und zuverlässig vorgenommen werden können, ohne einem Risiko evtl. mechanischer Verformungen durch das Fluid und damit einer Verfälschung von Messergebnissen ausgesetzt sein zu müssen. Des Weiteren sind Leiterplatten massenhaft erwerbbar, sodass diese kostengünstig als Bodenplatte für den Sensorchip eingesetzt werden kann.

Von besonderem Vorteil ist ferner, dass bei einer Anbringung eines Lötrings auf der Leiterplatte das Package des Sensorpackages als ein SMD-Bauteil bereitgestellt werden kann. Ein SMD-Bauteil (englisch: *surface mounted device*) bezeichnet ein Bauteil, welches eine direkte Anbindung auf eine weitere bzw. externe Anwendung ermöglicht, beispielsweise durch eine direkte Verbindung des Sensorpackages mittels Oberflächenmontage (englisch: *surface mounting technology*) an eine Hauptplatine. Vorteilhaft ist es nicht notwendig, beispielsweise Drahtverbindungen etc. zu implementieren, sodass eine erhebliche Platzersparnis in Bezug auf die Positionierung des Sensorpackages erzielt werden kann. Des Weiteren ist es von großem Vorteil, dass durch den Lötring eine vorteilhaft elektromagnetische Verträglichkeit (EMV) erzielt und Störungen in der Signalübertragung vermieden werden. Vorzugsweise kann der Lötring und/oder die Abdeckung, falls letzte ein elektrisch leitfähiges Material umfasst, derart verschaltet werden, dass eine oder beide der Komponenten geerdet sind bzw. auf GND liegen.

In einer weiteren bevorzugten Ausführungsform ist das Sensorpackage dadurch gekennzeichnet, dass die Abdeckung als eine Kappe oder als ein Deckelsubstrat vorliegt.

Mit der Abdeckung ist bevorzugt eine feste und insbesondere schützende Umhüllung für den Sensorchip gemeint. Dazu wird bevorzugt der Sensorchip auf der Bodenplatte angebracht und die Abdeckung mit dem der Bodenplatte verbunden. Durch eine ausgewählte Dimensionierung der Abdeckung lässt sich insbesondere die Ausgestaltung des Strömungskanals wählen, durch den das Fluid innerhalb des Sensorpackages verläuft, d. h. insbesondere zwischen der Bodenplatte und der Abdeckung. Durch die Aufbringung der Abdeckung auf der Bodenplatte wird vorteilhafterweise ein hermetischer Einschluss des Sensorchips innerhalb des Sensorpackages ermöglicht. Der hermetische Einschluss meint bevorzugt eine derartige Einkapselung, wobei bis auf den Eintrittsbereich und den Austrittsbereich kein fluidischer Stoffaustausch mit dem Sensorpackage stattfinden kann. Mithin wird insbesondere durch die Abdeckung eine Schutzfunktion für den Sensorchip erfüllt.

In bevorzugten Ausführungsformen kann die Abdeckung im Wesentlichen flach ausgestaltet sein, sodass vorzugsweise die Höhe der Abdeckung im Wesentlichen durch die Höhe des Sensorchips vorgegeben wird. In weiteren bevorzugten Ausführungsformen kann die Abdeckungen Vertiefungen und/oder Erhöhungen aufweisen, beispielweise in Form von Hohlräumen, Kavitäten, Korrugationen und/oder Rillen. Weiterhin kann es bevorzugt sein, dass der Strömungskanal, insbesondere ein Verlauf des Strömungskanals durch die Abdeckung mindestens teilweise bestimmt wird. So kann beispielweise der Strömungskanal mindestens teilweise zwischen dem Sensorchip und der Abdeckung verlaufen. Ebenfalls kann es bevorzugt sein, dass der Strömungskanal durch den Sensorchip hindurch verläuft. Ferner kann es bevorzugt sein, dass der Strömungskanal innerhalb einer Kavität des Sensorsensorchips mindestens teilweise, bevorzugt vollständig verläuft.

In einer weiteren bevorzugten Ausführungsform ist das Sensorpackage dadurch gekennzeichnet, dass der Sensorchip auf der Bodenplatte angebracht vorliegt und die Abdeckung mit der Bodenplatte derart verbunden ist, so dass die Abdeckung den Sensorchip mindestens teilweise, bevorzugt vollständig, überdeckt.

Durch den Bereich zwischen der Bodenplatte und der Abdeckung kann die Ausgestaltung des Strömungskanals gewählt werden. Insbesondere stellen die Bodenplatte und die Abdeckungen Begrenzungen für das Fluid dar, welches innerhalb des Sensorpackages durch den Strömungskanal strömt. Vorzugsweise wird der Sensorchip auf der Bodenplatte positioniert. Mithin kann die Bodenplatte als eine untere Begrenzung aufgefasst. Vor diesem Hintergrund kann dementsprechend die Abdeckung als eine obere Begrenzung aufgefasst werden. Dazu werden insbesondere die Abdeckung und die Bodenplatte miteinander verbunden. Hierdurch liegt eine mindestens teilweise Überdeckung, bevorzugt eine vollständige Überdeckung, des Sensorchips durch die Abdeckung vor. Insbesondere liegt eine feste Verbindung zwischen dem Sensorchip und der Bodenplatte vor, um eine zuverlässige Messung des mindestens einen Strömungsparameters vornehmen zu können.

Vorzugsweise kann die Abdeckung durch eine Kappe oder ein Deckelsubstrat gebildet werden.

Eine Kappe bezeichnet bevorzugt eine gewölbte Abdeckung, mit einer oberen Decke und Seitenwänden, welche einen Hohlraum umschließen, in welchem der Sensorchip angeordnet werden kann. Die Kappe kann vorzugsweise mit der Bodenplatte über die Seitenwände verbunden, wobei die Verbindung der Seitenwände auf der Bodenplatte als Dichtkante bezeichnet werden kann. Die Kappe schließt somit vorzugsweise einen Sensorchip auf der Bodenplatte von oben ab.

Das Deckselsubstrat bezeichnet bevorzugt ein Substrat, mit dem der Sensorchip ebenfalls abgedeckt bzw. eingeschlossen werden kann. Das Deckelsubstrat kann ein gewöhnlicher Wafer oder ein SOI-Substrat sein. Es kann bevorzugt sein, dass das Deckelsubstrat eine Kavität aufweist, sodass ein Seitenbereich des Deckelsubstrates mit der Bodenplatte verbunden wird und die Kavität oberhalb des Sensorchips angebracht ist.

In einer bevorzugten Ausführungsform umfasst die Abdeckung ein Dielektrikum, wobei bevorzugt das Dielektrikum ausgewählt ist aus einer Gruppe umfassend Siliziumnitrid, Siliziumdioxid, Aluminiumoxid, Aluminiumnitrid, Polyimid und/oder ein polymeres Material.

In einer weiteren bevorzugten Ausführungsform umfasst die Abdeckung einen Halbleiter, wobei bevorzugt der Halbleiter ausgewählt ist aus einer Gruppe umfassend Monosilizium, Polysilizium, Germanium und/oder Chalkogenid.

In einer weiteren bevorzugten Ausführungsform umfasst die Abdeckung einen Leiter, wobei bevorzugt der Leiter ausgewählt ist aus einer Gruppe umfassend Aluminium, Titan Zink und/oder ein Edelmetall, vorzugsweise ausgewählt aus einer Gruppe umfassend bevorzugt Gold, Platin, Iridium, Palladium, Osmium, Silber, Rhodium und/oder Ruthenium.

Es kann ebenfalls bevorzugt sein, dass die Abdeckung eine oder mehrere Kombinationen von Materialien umfasst, die durch ein Dielektrikum, einen Halbleiter und/oder einen Leiter gebildet werden. So kann beispielsweise die Abdeckung einen metallisch beschichteten Thermoplast umfassen, welcher in einem Spritzguss bereitgestellt und anschließend beschichtet wurde.

In einer weiteren bevorzugten Ausführungsform ist das Sensorpackage dadurch gekennzeichnet, dass der Sensorchip mit der Bodenplatte direkt oder über ein Verbindungsmittel verbunden ist, wobei bevorzugt das Verbindungsmittel einen Klebstoff, ein Lotmaterial und/oder ein Bondmaterial umfasst.

Eine direkte Verbindung zwischen dem Sensorchip und der Bodenplatte meint bevorzugt eine unmittelbare Verbindung, d. h. eine Verbindung, ohne dass eine Zwischenkomponente (als Verbindungsmittel) vorliegt, sondern der Sensorchip direkt auf der Bodenplatte aufgebracht vorliegt. Eine direkte Verbindung kann beispielsweise durch eine Pressverbindung bereitgestellt werden. Auch einige Bondverbindungen können vorzugsweise für eine direkte Verbindung eingesetzt werden, beispielsweise nach einer Anwendung eines Thermokompressionsbonden.

Eine Verbindung über ein Verbindungsmittel meint bevorzugt, dass zwischen der Bodenplatte und dem Sensorchip jenes Verbindungsmittel vorliegt, welches eine langanhaltende Verbindung zwischen der Bodenplatte und dem Sensorchip ermöglicht. Die genannten bevorzugten Verbindungsmittel umfassend Verbindungsmittel einen Klebstoff, ein Lotmaterial und/oder ein Bondmaterial haben sich für eine besonders stabile und fluiddichte Verbindung als vorteilhaft erwiesen. Eventuelle Vibrationen und/oder Erschütterungen des Sensorchips bei der Umströmung durch das Fluid durch den Strömungskanal können vorteilhaft vermieden werden, sodass eine präzise Messung des mindestens einen Strömungsparameters des Fluides ausführbar ist.

Der durchschnittliche Fachmann ist in der Lage eine bevorzugte Verbindungsart zwischen Sensorchip und Bodenkomponente in Abhängigkeit einer konkreten Ausgestaltung, Dimensionierung und/oder Materialauswahl auszuwählen.

In einer weiteren bevorzugten Ausführungsform ist das Sensorpackage dadurch gekennzeichnet, dass das Heizelement ein elektrisches Heizelement ist, bevorzugt ein Heizwiderstand ist.

Das Heizelement bezeichnet bevorzugt die Komponente des thermischen Sensors, von der durch Abgabe einer Wärmeenergie das Wärmefeld bzw. der Wärmestrom ausgeht. Ein elektrisches Heizelement bezeichnet bevorzugt ein Heizelement, welches in der Lage ist, elektrische Energie in Wärmeenergie umzuwandeln, der im erfindungsgemäßen Kontext als Wärmefeld verwandt und zur Sensorkomponente, vorzugsweise dem Temperatursensor, übertragen wird. Die Wärmeenergie bzw. das Wärmefeld wird bei einem elektrischen Heizelement vorzugsweise derart erzeugt, dass ein elektrisch leitfähiges Material verwandt wird, welches von einem elektrischen Strom durchflossen und durch Joulesche Wärme erhitzt wird. Ein Heizwiderstand hat sich hierfür als besonders geeignet erwiesen. Vorzugsweise umfasst dieser metallische Legierungen, die auch bei besonders hohen Temperaturen, nicht schmelzen und/oder oxidieren.

In einer weiteren bevorzugten Ausführungsform ist der Sensorchip dadurch gekennzeichnet, dass die Sensorkomponente durch einen Temperatursensor gebildet wird, wobei bevorzugt der Temperatursensor ausgewählt ist aus einer Gruppe umfassend ein Thermoelement, eine Diode, ein Thermistor und/oder eine Thermosäule.

Ein Temperatursensor als eine bevorzugte Sensorkomponente ist in der Lage, den Einfluss des Fluides auf das Wärmefeld durch eine Temperaturmessung zu ermitteln. Die genannten bevorzugten Optionen umfassend ein Thermoelement, eine Diode, ein Thermistor und/oder eine Thermosäule haben sich für eine zuverlässige Temperaturmessung als besonders nützlich erwiesen.

Ein Thermistor meint bevorzugt ein Bauelement umfassend einen elektrischen Widerstand, dessen Wert sich mit der Temperatur reproduzierbar ändert. Thermistoren unterteilen sich in ihren Temperaturverhalten in Heißleiter und Kaltleiter. Ein Heißleiter weist einen negativen Temperaturkoeffizienten auf und ist in der Lage, elektrischen Strom im heißen Zustand besser zu leiten als im kalten Zustand. Ein Kaltleiter weist einen positiven Temperaturkoeffizienten auf und kann im kalten Zustand besser elektrisch leiten als im heißen Zustand. Im Kontext der Erfindung kann vorzugsweise ein Heißleiter oder ein Kaltleiter als Thermistor verwandt werden. Mittels eines Thermistors lässt sich auf einfache und präzise Weise anhand eines sich ändernden elektrischen Widerstandes Rückschlüsse auf eine Modulation des Wärmefeldes und mithin mindestens ein Strömungsparameter des Fluides bestimmen.

Mit einem Thermoelement ist bevorzugt eine Anordnung umfassend ein Paar elektrisch leitfähiger Materialien gemeint, die an einem Ende miteinander verbunden sind und aufgrund des thermoelektrischen Effektes einen Rückschluss auf die gemessene Temperatur zulassen. Dabei wird elektrische Energie bei einer Temperaturdifferenz entlang der Anordnung bereitgestellt. Eine Thermosäule bezeichnet ein Element, welches mehrere Thermoelemente aufweist. Die Thermoelemente der Thermosäule sind bevorzugt elektrisch in Reihe und thermisch parallelgeschaltet.

Die Messstelle des Thermoelements oder der Thermosäule wird als Heißstelle, heißes Ende oder durch die englischen Begriffe *hot end* oder *hot junction* bezeichnet und bildet ein Ende eines Thermoelements. Das andere Ende, welches analog als Kaltstelle, kaltes Ende oder durch die englischen Begriffe *cold end* oder *cold junction* bezeichnet wird, bezeichnet eine als Referenz dienende Vergleichsstelle, um einen Temperaturunterschied feststellen zu können. Vorzugsweise wird eine elektronische Schaltung und/oder eine Recheneinheit zur Verarbeitung der Temperaturmessung mit der *cold junction* verbunden.

Auch eine Diode kann als Temperatursensor und damit als eine bevorzugte Sensorkomponente fungieren. Hierbei kann beispielsweise ausgenutzt werden, dass eine Durchlassspannung einer Diode sich mit der Temperatur im Wesentlichen linear ändert. Umso höher die Temperatur ist, desto geringer ist die Durchlassspannung und umgekehrt. Dementsprechend kann anhand der Änderung einer Durchlassspannung Rückschlüsse auf eine Änderung der Temperatur gezogen werden.

In einer weiteren bevorzugten Ausführungsform fungiert das Heizelement selbst als Sensorkomponente, d. h., dass vorzugsweise eine Sensorkomponente durch das Heizelement bereitgestellt werden kann, ohne dass ein Temperatursensor als Sensorkomponente eingesetzt wird. Die Wirkung des Heizelementes als Sensorkomponente kann beispielsweise wie die aus dem Stand der Technik bekannte 3-Omega-Methode ermöglicht werden. Bei der 3-omega-Methode wird eine thermische Eigenschaft, wie z. B. eine Wärmeleitfähigkeit, bestimmt. Dabei wird ein Heizelement selbst als Temperatursensor verwandt und mit einem oszillierenden Steuerungssignal eingespeist. Durch die eingespeiste Leistung ändert sich die Temperatur des Heizelementes mit der gleichen Frequenz des Ansteuerungssignals. Die Amplitude und die Phasenverschiebung gegenüber der Einspeiseleistung ist abhängig von der Wärmeleitfähigkeit und der Frequenz. Die Temperaturoszillationen führen zu einer Widerstandoszillationen des Heizelementes, welche unter anderem durch eine Widerstandamplitude beschrieben werden kann, die wiederrum abhängig von einem Temperaturkoeffizienten des elektrischen Widerstands des Heizelementes ist. Hieraus lässt sich durch eine Anwendung des ohmschen Gesetzes die Spannung über das Heizelement berechnen, welche eine Komponente mit der 3-fachen Frequenz (3ω) und eine entsprechende Amplitude enthält, die proportional zur Temperaturamplitude des Heizelementes ist.

In einer weiteren bevorzugten Ausführungsform ist das Sensorpackage dadurch gekennzeichnet, dass der Sensorchip eine Membran aufweist, auf welcher der thermische Sensor positioniert ist, wobei bevorzugt die Membran ein elektrisches leitfähiges Material und/oder ein dielektrisches Material umfasst, wobei bevorzugt das elektrisch leitfähige Material ausgewählt ist aus einer Gruppe umfassend Halbleiter und/oder Metalle, insbesondere Silizium, Polysilizium, Graphen, Chalkogenid, wobei bevorzugt das dielektrische Material ausgewählt ist aus einer Gruppe umfassend Siliziumnitrid, Siliziumdioxid, Aluminiumoxid, Aluminiumnitrid, Polyimid und/oder ein polymeres Material.

Die Membran bezeichnet eine bevorzugte Komponente des Sensorchips, welche flächig ausgestaltet ist. Die flächige Ausgestaltung der Membran meint bevorzugt, dass Maße wie eine Länge und/oder Breite um ein Vielfaches höher sind als eine dazu orthogonale Höhe bzw. Dicke der Membran. So kann die Länge und/oder Breite um einen Faktor 1,5, 2, 5, 10, 100, 1 000, 10 000 oder mehr höher sein als die Dicke. Vorzugsweise beträgt die Dicke der Membran zwischen ca. 0,1 - 20 µm, bevorzugt zwischen ca. 0,2 - 10 µm, besonders bevorzugt zwischen ca. 0,5 - 5µmganz besonders bevorzugt zwischen ca. 0,5 - 2 µm.

Die Membran dient insbesondere der Positionierung des thermischen Sensors. Durch die bevorzugte Membran soll vorzugsweise eine thermische Isolation des durch das Heizelement bereitgestellten Wärmefeldes und eine Trägerfunktion für den thermischen Sensor erfüllt werden. Weiterhin kann es auch bevorzugt sein durch die Membran eine zuverlässige Medientrennung zu gewährleisten, in dem die Membran einer mindestens teilweisen Abdeckung eines darunter verlaufenden Strömungskanals dient.

Die bevorzugten Materialien für die Membran haben sich dahingehend als vorteilhaft erwiesen, dass sie neben der hervorragenden Ausgestaltungsmöglichkeit als Membran auch eine zuverlässige thermische Isolation bieten, sodass eine durch die Membran bedingte Wärmeleitung verringert oder vermieden wird. Hierdurch wird die Genauigkeit der Messergebnisse weiter verbessert, sodass im Wesentlichen der Einfluss des Fluides auf das Wärmefeld relevant bleibt. Ferner haben sich die bevorzugten Materialien hinsichtlich einer Verarbeitung zur Bereitstellung der Membran und einer hinreichenden mechanischen Stabilität als besonders vorteilhaft erwiesen. Insbesondere ist die Membran zudem bevorzugt dazu ausgelegt eventuelle Schwingungen durch die Strömung des Fluides zu vermeiden, um Verfälschungen des Messergebnisses zu reduzieren.

Der Bereich der Membran, auf welcher der thermische Sensor positioniert wird, umfasst bevorzugt ein dielektrisches Material. Ebenfalls kann bevorzugt die Membran ein elektrisch leitfähiges Material umfassen, sodass eine elektrische Kontaktierung zum thermischen Sensor bereitgestellt werden kann.

In einer weiteren bevorzugten Ausführungsform ist das Sensorpackage dadurch gekennzeichnet, dass der Sensorchip eine Kavität aufweist, oberhalb derer sich eine Membran erstreckt, auf welcher der thermische Sensor positioniert ist.

Vorzugsweise umfasst der Sensorchip eine Trägerstruktur, an der die Kavität angebracht ist. Die Die Trägerstruktur umfasst bevorzugt eine seitliche Begrenzung, insbesondere in Form von Seitenwänden, entlang derer sich die Membran über der Kavität erstreckt. Durch die Kavität wird vorteilhaft eine thermische Isolation erzielt. Insbesondere wird durch die Einbringung der Kavität am Sensorchip erreicht, dass das von einem Heizelement bereitgestellte Wärmefeld vorwiegend, vorzugsweise im Wesentlichen ausschließlich, durch das Fluid beeinflusst wird und eine Verfälschung von Messergebnissen durch eine Wärmeleitung durch den Sensorchip selbst, insbesondere durch die bevorzugte Trägerstruktur, reduziert wird.

In einer weiteren bevorzugten Ausführungsform ist das Sensorpackage dadurch gekennzeichnet, dass der Sensorchip eine Apertur aufweist, welche vorzugsweise an der Membran angebracht ist, wobei ferner die Apertur als ein Abschnitt des Strömungskanals vorliegt oder der Strömungskanal zumindest teilweise innerhalb der Kavität verläuft. Es kann ebenfalls bevorzugt sein, dass der Strömungskanal im Wesentlichen vollständig unterhalb der Kavität des Sensorchips verläuft.

In einer weiteren bevorzugten Ausführungsform ist das Sensorpackage dadurch gekennzeichnet, dass der Strömungskanal innerhalb des Sensorpackages verläuft und der Eintrittsbereich und der Austrittbereich des Strömungskanals durch Öffnungen an der Bodenplatte und/oder der Abdeckung vorliegen.

Der Strömungskanal gibt insbesondere einen Pfad vor, durch den das Fluid innerhalb des Sensorpackages strömen kann. Durch die Ausgestaltung des Strömungskanals kann insbesondere zudem eine hinreichende Nähe des strömenden Fluides in Bezug auf den thermischen Sensor gewährleistet werden, sodass eine Messung von Strömungsparametern des Fluides anhand einer Modulation bzw. eines Einflusses des vom Heizelement bereitgestellten Wärmefeld möglich ist. Anders ausgedrückt, wird durch den Strömungskanal ein Pfad für die Strömung des Fluides bereitgestellt, durch den das Fluid sich ausbreiten kann, um von dem thermischen Sensor ausgemessen zu werden. Die Beeinflussung des Fluides, welches durch den Strömungskanal strömt, auf das Wärmefeld wird insbesondere anhand der Temperaturantwort festgestellt. Mittels der Temperaturantwort kann der mindestens eine Strömungsparameter des Fluides gemessen werden.

Um die Strömung in den Strömungskanal durch das Sensorpackage ermöglichen zu können, werden Öffnungen am Sensorpackage eingebracht, welche als Eintrittsbereich und/oder Austrittsbereich fungieren. Mithin kann durch die Öffnung der Eintritt des Fluides in den Sensorpackages sowie ein Austritt aus dem Sensorpackage hinaus ermöglicht werden. Für die Einbringung der Öffnungen am Sensorpackage liegt vorteilhaft eine Vielzahl von möglichen Optionen vor.

In einer bevorzugten Ausführungsform ist das Sensorpackage dadurch gekennzeichnet, dass der Eintrittsbereich als eine Öffnung in der Abdeckung und der Austrittsbereich als eine Öffnung in der Abdeckung vorliegen.

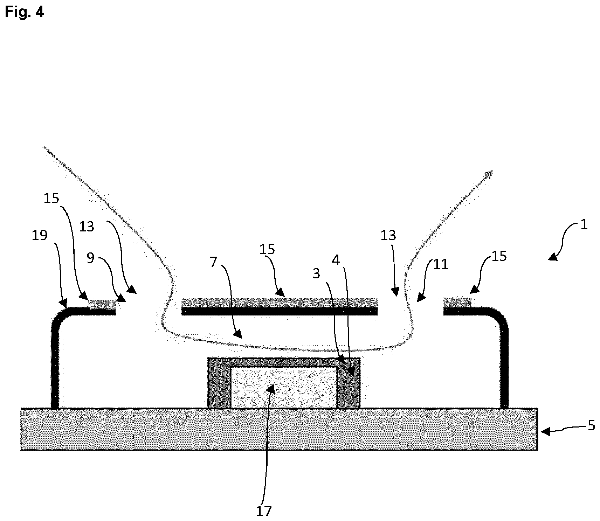

Mithin kann das Fluid durch die Öffnung, die als Eintrittsbereich fungiert, über die Abdeckung in das Sensorpackage hineingelangen und über die Öffnung, die als Austrittsbereich fungiert, über die Abdeckung aus dem Sensorpackage hinausgelangen. Die bevorzugte Ausführungsform, bei der der die Öffnungen für einen Eintrittsbereich und einen Austrittsbereich an der Abdeckung eingebracht sind, eignet sich besonders gut, um das Sensorpackage über die Abdeckung mit einer Hauptplatine und/oder mit einem fluidischen Anschluss zu verbinden (vgl. Fig. 4).

In einer weiteren bevorzugten Ausführungsform ist das Sensorpackage dadurch gekennzeichnet, dass der Eintrittsbereich als eine Öffnung in der Bodenplatte und der Austrittsbereich als eine Öffnung in der Abdeckung oder der Eintrittsbereich als eine Öffnung in der Abdeckung und der Austrittsbereich als eine Öffnung in der Bodenplatte vorliegt.

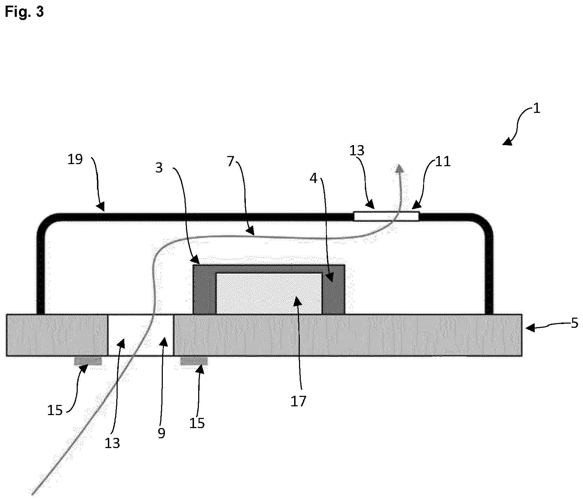

In der erst genannten Ausführungsform gelangt das Fluid in den Sensorpackage über die Öffnung an der Bodenplatte, welche als Eintrittsbereich fungiert. Dabei breitet sich das Fluid innerhalb des Strömungskanals aus und gelangt in eine hinreichende Nähe des thermischen Sensors, sodass ein Einfluss auf das Wärmefeld ausgeübt werden kann, das vom Heizelement bereitgestellt wird. Über die Temperaturantwort, welche von der Sensorkomponente aufgenommen wird, kann wie beschrieben ein Rückschluss auf den mindestens einen Strömungsparameter des Fluides erfolgen. Über die Öffnung an der Abdeckung, die als Austrittsbereich wirkt, kann das Fluid das Sensorpackage verlassen (vgl. auch Fig. 3).

In der zweit genannten Ausführungsform gelangt das Fluid in umgekehrter Weise über eine Öffnung in der Abdeckung, welche als Eintrittsbereich fungiert in das Sensorpackage und strömt über eine Öffnung in der Bodenplatte wieder hinaus. Auch in diesem Fall verläuft der Strömungskanal durch den Raum, welcher von Bodenplatte und Abdeckung gebildet wird.

Insofern kann durch eine geometrische Ausgestaltung der Abdeckung, beispielsweise einer Dimensionierung einer Kappe und/oder Deckelsubstrates, Einfluss auf die Weglänge des Strömungspfades genommen.

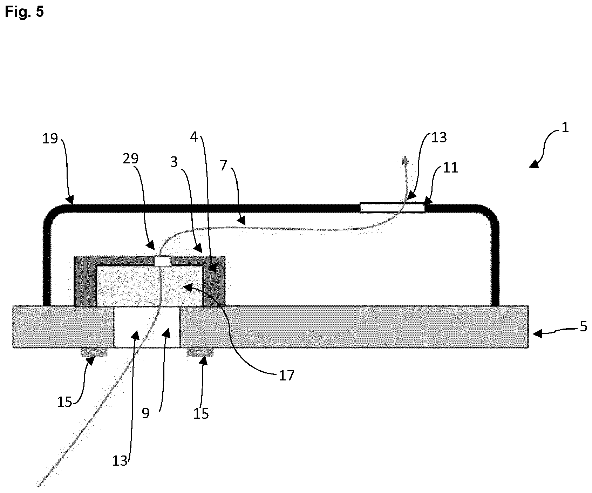

In einer weiteren bevorzugten Ausführungsform ist das Sensorpackage dadurch gekennzeichnet, dass mindestens eine Öffnung zur Bildung des Eintrittsbereiches und/oder des Austrittsbereiches an Bodenplatte und/oder der Abdeckung vorliegt und eine Apertur innerhalb des Sensorchips vorliegt, sodass der Strömungskanal mindestens teilweise durch die Apertur am Sensorchip verläuft. Die Apertur im Sensorchip kann beispielsweise durch eine Öffnung innerhalb einer Membran gebildet werden, auf welcher der thermische Sensor positioniert ist (vgl. auch Fig. 5). Bevorzugt kann der thermische Sensor ein Heizelement und eine Sensorkomponente, beispielsweise einen Temperatursensor, umfassen, welche in hinreichender Nähe zur Apertur angebracht vorliegen. Hierdurch kann ein besonders starker Einfluss des Fluides auf das vom Heizelement bereitgestellte Wärmefeld genutzt werden, um eine sensitive Messung auszuführen.

In einer weiteren bevorzugten Ausführungsform ist das Sensorpackage dadurch gekennzeichnet, dass der Eintrittsbereich als eine Öffnung in der Bodenplatte und der Austrittsbereich als eine Öffnung in der Bodenplatte vorliegen.

Dabei tritt das Fluid in das Sensorpackage über den Eintrittsbereich hinein, welcher als Öffnung in der Bodenplatte vorliegt. Nach dem Eintritt des Fluides in das Sensorpackage ist eine Einflussnahme des Fluides auf das vom Heizelement bereitgestellte Wärmefeld möglich. Über die Öffnung an der Bodenplatte, welche als Austrittsbereich fungiert, kann das Fluid den Sensorpackage verlassen. Dabei kann es bevorzugt sein, dass die Öffnungen derart an der Bodenplatte eingebracht sind, dass der Strömungskanal teilweise innerhalb der bevorzugten Kavität verläuft, welche der Sensorchip umfasst und über die sich der thermische Sensor befindet. Die Kavität meint bevorzugt eine Kavität unterhalb einer Membran, auf welcher der thermische Sensor vorzugsweise zur Erfassung einer Temperaturantwort angebracht ist.

In einer weiteren bevorzugten Ausführungsform ist das Sensorpackage dadurch gekennzeichnet, dass der Sensorchip ein Substrat aufweist, wobei der thermische Sensor auf einer Vorderseite des Substrates positioniert vorliegt und mindestens ein Abschnitt des Strömungskanals unterhalb des thermischen Sensors innerhalb des Substrates gebildet wird, welcher ausgehend von einer Rückseite des Substrates durch bereichsweise Entfernung des Substrates gebildet wurde, wobei das Substrat vorzugsweise monolithisch ausgestaltet ist.

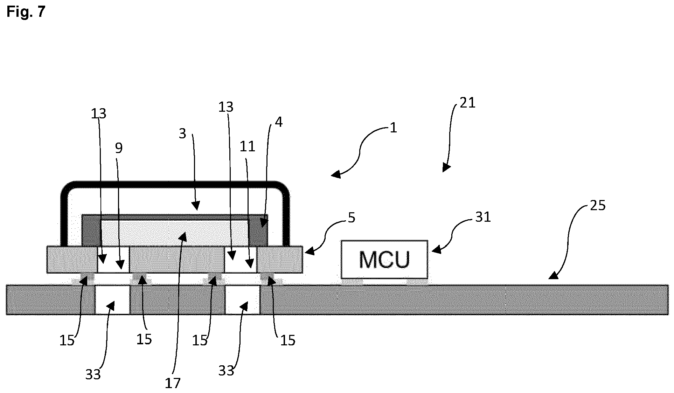

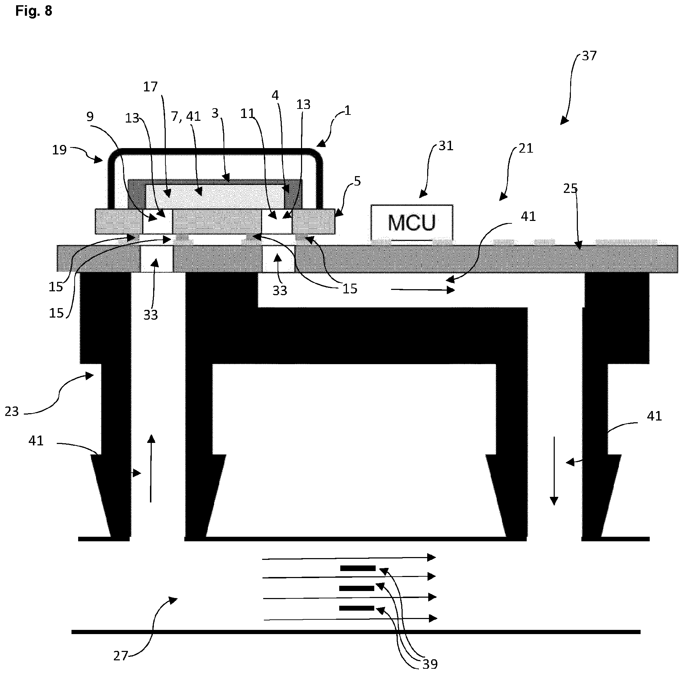

Vorzugsweise umfasst das Substrat einen korrespondierenden Eintrittsbereich und einen korrespondierenden Austrittsbereich. Damit ist bevorzugt gemeint, dass das Substrat einen korrespondierenden Eintrittsbereich in den Abschnitt des Strömungskanals innerhalb des Sensorchips umfasst, der fluidisch mit dem Eintrittsbereich am Sensorpackage verbunden ist. Bevorzugt ist korrespondierende Austrittsbereich am Substrat mit dem Austrittsbereich am Sensorpackage fluidisch verbunden. Mithin gelangt das Fluid über den Eintrittsbereich des Sensorpackages in dieses hinein und durchströmt den Abschnitt des Strömungskanal innerhalb des Substrates des Sensorchips, in dem es über den korrespondieren Eintrittsbereich gelangt. Über den korrespondierenden Austrittsbereich des Substrates und den Austrittsbereich am Sensorpackage kann das Fluid das Package wieder verlassen (vgl. auch Fig. 7 und 8).

Das Substrat kann insbesondere dazu dienen, die bevorzugte Trägerstruktur für den Sensorchip zu bilden, auf der der thermische Sensor angebracht ist. Entsprechend ist es bevorzugt, dass der thermische Sensor auf einer Vorderseite des Substrates angebracht wird, um eine Messung des Fluides ermöglichen zu können.

Das Substrat kann beispielsweise ein Glas, eine Keramik und/oder ein Halbleitermaterial, beispielsweise Monosilizium, Polysilizium, Siliziumcarbid, Siliziumgermanium, Germanium, Galliumarsenid und/oder Galliumnitrid umfassen.

Insbesondere ist es bevorzugt, dass das Substrat monolithisch ausgestaltet ist. Mit monolithisch ist im erfindungsgemäßen Kontext insbesondere ein einstückiges Substrat gebaut. Mithin ist es bevorzugt, dass das Substrat als ein einzelnes Substrat vorliegt und nicht mehr stückig durch Verbindung (z. B. Bonding) von zwei oder mehr Substraten erhalten wurde. Ein unbearbeitetes Substrat, d. h. eine Substrat, in dem noch kein Strömungskanal eingebracht ist, kann dementsprechend vorzugsweise als ein monolithischer Block bereitgestellt werden, d h. als ein Block, welches im Wesentlichen aus dem Substratmaterial besteht. Durch die monolithische Ausgestaltung des Substrates wird insbesondere ein stackartiger Aufbau für den thermischen Sensor vermieden, d. h. es werden nicht mehrere Substrate aufeinandergestapelt und/oder miteinander verbunden.

Stattdessen wird der Strömungskanal in der bevorzugten Ausführungsform vorzugsweise in einem einzigen monolithischen Substrat eingebracht. Die Vorderseite bezeichnet vorzugsweise eine obere Seite des Substrates, auf welcher der thermische Sensor angebracht vorliegt, vorzugsweise auf einer Membran, welche von dem Substrat gehalten wird, wie obig erläutert. Die Rückseite des Substrates bezeichnet eine Oberfläche, die gegenüberliegend der Vorderseite vorliegt, d. h. bevorzugt gegenüberliegend von einer (oberen) Seite des Substrates, auf welcher der thermische Sensor positioniert vorliegt.

Die bereichsweise Entfernung des Substrates ausgehend von der Rückseite kann derart erfolgen, dass der Strömungskanal hinsichtlich seiner Höhe im Wesentlichen, oder bevorzugt exakt, der Höhe des Substrates entspricht. Ebenfalls kann es bevorzugt sein, dass die bereichsweise Entfernung des Substrates derart erfolgt, dass eine Restdicke am Substrat verbleibt. Die bereichsweise Entfernung des Substrates zur Bereitstellung des Strömungskanals meint insbesondere eine Entfernung von Abschnitten des Substrates (z. B. durch bekannte Ätzverfahren für Halbleitermaterialien), um eine Ausgestaltung des Strömungskanals vorzunehmen. Insbesondere liegt durch bzw. nach der bereichsweisen Entfernung des Substrates ein freies Volumen innerhalb des Substrates vor, welches innerhalb des Sensorchips einen Abschnitt des Strömungskanals bildet. Der Abschnitt des Strömungskanal kann somit vorzugsweise seitlich durch das Substrat begrenzt sein, während der Abschnitt des Strömungskanal nach oben durch eine Membran begrenzt wird, welche vom Substrat gehalten wird. Der Abschnitt des Strömungskanal kann aber auch durch das Substrat selbst nach oben begrenzt sein, sofern bei einer rückseitigen Entfernung des Substrates vorzugsweise eine obere Restdicke verbleibt.

Nach unten wird der Abschnitt des Strömungskanal vorzugsweise hingegen durch die Bodenplatte, begrenzt, deren Öffnungen wie erläutert mit einem Eintritts- bzw. Austrittsbereich für einen Einlass bzw. Auslass des Fluides in den Abschnitt des Strömungskanal innerhalb des Substrates des Sensorchips korrespondieren.

Vorteilhafterweise kann durch die von der Rückseite ausgehende bereichsweise Entfernung in einem Prozessablauf die Strukturierung des Abschnitts des Strömungskanals vorgenommen werden. Es kann ebenfalls bevorzugt sein, dass mehrere Prozessschritte ausgeführt werden, um den Abschnitt des Strömungskanals bereitzustellen. Der Eintrittsbereich stellt einen Übergangsbereich dar, über den das Fluid in den Abschnitt des Strömungskanal innerhalb des Substrates hineingelangt. Entsprechend stellt der Austrittsbereich einen Übergangsabschnittes des Strömungskanals dar, durch den das Fluid den Abschnitt des Strömungskanal innerhalb des Substrates verlassen kann.

Dies kann vorteilhafterweise unter erheblich kontrollierten Gegebenheiten erfolgen, sodass beispielsweise Turbulenzen vermieden werden, und damit Qualität und Sensitivität der Messung des mindestens einen Strömungsparameters verbessert wird.

Weiterhin lassen sich die fluidischen Eigenschaften des Abschnittes des Strömungskanals innerhalb des monolithischen Substrates vorteilhaft besonders präzise und konstant einstellen. So kann beispielsweise eine Breite des Abschnitts des Strömungskanals durch bekannte Ätzverfahren zur bereichsweisen Entfernung des Substrats äußerst präzise eingestellt werden. Fehlertoleranzen, welche inhärent bei der Bildung von Strömungskanälen in zusammengesetzten Stacks aufgrund der Verbindungstechnik entstehen könnten, werden vermieden. Durch die Bildung des Abschnittes des Strömungskanals innerhalb des monolithischen Substrates kann zudem gewährleistet werden, dass die Abmessungen des Abschnittes des Strömungskanals sich konstant verhalten und insbesondere nicht von dem Fließverhalten des Fluides selbst beeinflusst werden.

In einem weiteren Aspekt betrifft die Erfindung eine Sensorpackageanordnung umfassend
a. ein Sensorpackage nach einem der vorherigen Ansprüche nach dem obig Beschriebenen, und
b. eine Hauptplatine,
dadurch gekennzeichnet, dass das Sensorpackage auf der Hauptplatine installiert vorliegt.

Die Sensorpackageanordnung umfasst insbesondere das obig beschriebenen Sensorpackage und eine Hauptplatine.

Die Hauptplatine (englisch: *mother board*) bezeichnet eine zentrale Platine, auf der elektronische Komponenten angebracht vorliegen, um eine Funktionalität des Sensorpackages, insbesondere im Hinblick auf die Ansteuerung des Heizelementes und/oder der Auswertung der Temperaturantwort, gewährleisten zu können. Insbesondere können an der Hauptplatine Komponenten wie z. B. ein Sockel für eine elektronische Schaltung, die elektronische Schaltung selbst, Steckplätze, BIOS-Chips, Schnittstellen-Bausteine und/oder Steckplätze für Erweiterungskarten montiert sein.

Das Sensorpackage ist bevorzugt auf der Hauptplatine installiert. Das kann bevorzugt bedeuten, dass eine mechanische und/oder elektronische Verbindung zwischen dem Sensorpackage und der Hauptplatine gegeben ist. Dabei liegt insbesondere eine hinreichend stabile Verbindung vor, die sowohl für eine mechanische als auch eine elektronische Verbindung zutrifft. Vorteilhafterweise wird hierdurch erreicht, dass durch die Strömung des Fluides durch den Strömungskanal des Sensorpackages eine Benachteiligung auf eine Verbindungsart vermieden wird.

Von besonderem Vorteil ist, dass bei einer Anbringung eines Lötrings auf der Leiterplatte das Package des Sensorpackages als ein SMD-Bauteil vorliegen kann, sodass eine direkte Verbindung des Sensorpackages auf eine Leiterplatte mittels Oberflächenmontage ermöglicht wird. Vorteilhaft ist es nicht notwendig, beispielsweise Drahtverbindungen etc. zu implementieren. Hierdurch kann eine erhebliche Platzersparnis in Bezug auf die Positionierung des Sensorpackages erzielt werden. Des Weiteren ist es von großem Vorteil, dass durch den Lötring eine vorteilhaft elektromagnetische Verträglichkeit (EMV) erzielt und Störungen in der Signalübertragung vermieden werden. Vorzugsweise kann der Lötring und/oder die Abdeckung, falls letzte ein elektrisch leitfähiges Material umfasst, derart verschaltet werden, dass eine oder beide der Komponenten geerdet sind bzw. auf GND liegen.

In einer weiteren bevorzugten Ausführungsform ist die Sensorpackageanordnung dadurch gekennzeichnet, dass die Hauptplatine Hauptplatinenöffnungen aufweist und die Öffnungen zur Bereitstellung eines Eintrittsbereiches und eines Austrittbereiches des Sensorpackages über das Dichtmaterial mit den Hauptplatinenöffnungen verbunden vorliegen.

Anders beschrieben, kann durch das Dichtmaterial am Sensorpackage eine Verbindung zwischen der Hauptplatine und der Sensorpackageanordnung ermöglicht werden. Dabei kann insbesondere eine direkte Anbringung der Hauptplatinenöffnungen an dem Eintrittsbereich und dem Austrittsbereich des Sensorpackages ermöglicht werden. Hierdurch kann das Fluid in die Sensorpackageanordnung gelangen, in dem es über eine Hauptplatinenöffnung den Eintrittsbereich durchströmt und über den Strömungskanal durch den Austrittsbereich und einer weiteren Hauptplatinenöffnung die Sensorpackageanordnung verlässt. Ferner kann insbesondere durch das Dichtmaterial vorteilhaft eine passgenaue Verbindung des Eintrittsbereiches und des Austrittsbereiches mit den Hauptplatinenöffnungen ermöglicht werden.

In einer weiteren bevorzugten Ausführungsform ist die Sensorpackageanordnung dadurch gekennzeichnet, dass die Sensorpackageanordnung eine elektronische Schaltung aufweist, die dazu konfiguriert ist, den mindestens einen Strömungsparameter auf Basis einer Messung durch die Sensorkomponente zu bestimmen, wobei die elektronische Schaltung bevorzugt auf der Hauptplatine angebracht vorliegt.

Im Sinne der Erfindung bezeichnet eine elektronische Schaltung vorzugsweise einen Zusammenschluss von elektrischen oder elektromechanischen Einzelelementen zu einer funktionsgerechten Anordnung. Vorzugsweise erlaubt die elektronische Schaltung Daten bzw. elektrische Signale zu senden, zu empfangen und/oder zu verarbeiten.

Bevorzugte elektronische Schaltungen umfassen ohne Beschränkung eine integrierte Schaltung (IC), anwendungsspezifische integrierte Schaltungen (ASIC), eine programmierbare logische Schaltung (PLD), ein Field Programmable Gate Array (FPGA), einen Mikroprozessor, einen Mikrocomputer, eine speicherprogrammierbare Steuerung und/oder eine sonstige elektronische, bevorzugt programmierbare, Schaltung.

Vorzugsweise ist die elektronische Schaltung dazu konfiguriert, Messdaten der Sensorkomponente zu empfangen und/oder Steuersignale, beispielsweise - bzw. Steuerbefehle, an das Heizelement zu geben, um das Wärmefeld zu erzeugen.

Vorzugsweise kann die elektronische Schaltung dazu eingerichtet sein, in Abhängigkeit der Messdaten der Sensorkomponente eine Regelung des Heizelementes vorzunehmen. Bevorzugt ist die elektronische Schaltung dazu konfiguriert, nach einer Messung der Sensorkomponente einen Befehl zur Erzeugung des Wärmefeldes an das Heizelement zu geben, beispielsweise um die Wärmeabgabe zu erhöhen, konstant zu halten oder zu verringern.

In bevorzugten Ausführungsformen kann die elektronische Schaltung zudem dazu konfiguriert sein, die von der Sensorkomponente aufgenommenen Messdaten hinsichtlich der Modulation des Wärmefeldes zu verarbeiten. Das Verarbeiten von Daten meint bevorzugt, dass die elektronische Schaltung dazu konfiguriert ist, Rechenoperationen und/oder Rechenschritte vorzunehmen, beispielsweise mit aufgenommenen Messdaten der Sensorkomponente. Insbesondere kann mithilfe der elektronischen Schaltung festgestellt werden, welcher Unterschied zwischen einem Grundwert des Wärmestromes und der an der Sensorkomponente gemessenen Messdaten vorliegt.

Die elektronische Schaltung kann somit als eine Auswerte-, Auslesungs- und/oder Ansteuerungselektronik vorliegen, welche eine Ansteuerung des Heizelementes, eine Auslesung der Sensorkomponente und/oder Auswertung der Messdaten ermöglicht. Sofern eine Auswertung vorgenommen wird, kann die elektronische Schaltung auch als Recheneinheit bezeichnet werden.

Der Begriff "Recheneinheit" bezieht sich vorzugsweise auf ein beliebiges Gerät oder eine beliebige Einheit, die dazu konfiguriertet werden kann, Rechenoperationen durchzuführen. Bevorzugt ist die Recheneinheit beispielsweise ein Prozessor, ein Prozessorchip, ein Mikroprozessor und/oder ein Mikrocontroller, das vorzugsweise dazu konfiguriert ist, eine Auswertung der Modulation des Wärmefeldes vorzunehmen. Die Recheneinheit kann auch bevorzugt eine programmierbare Leiterplatte sein. Die Recheneinheit kann auch vorzugsweise ein computerverwendbares oder computerlesbares Medium, wie eine Festplatte, einen Direktzugriffsspeicher (RAM), einen Festwertspeicher (ROM), einen Flash-Speicher usw. umfassen.

Verfahrensschritte zur Bestimmung des mindestens einen Strömungsparameters des Fluides, wie hierin beschrieben, werden vorzugsweise von der elektronischen Schaltung bzw. Recheneinheit durchgeführt. Die Formulierung "dazu konfiguriert ist" meint bevorzugt, dass auf der elektronischen Schaltung bzw. Recheneinheit ein Computercode und/oder eine Software installiert ist, um den Verfahrensschritt durchzuführen, beispielsweise um zu überprüfen, inwiefern eine Modulation des Wärmefeldes hervorgerufen wurde und welche Parameter des Fluides dafür maßgeblich waren. Der Computercode und/oder die Software zur Auswertung der Modulation des Wärmefeldes kann in einer beliebigen Programmiersprache oder einer modellbasierten Entwicklungsumgebung geschrieben sein, z. B. in C/C++, C#, Objective-C, Java, Basic/VisualBasic, MATLAB, Simulink, StateFlow, Lab View und/oder Assembler.

Der Computercode und/oder die Software, welche bevorzugt auf der elektronischen Schaltung oder Recheneinheit installiert ist, um insbesondere eine Auswertung der Modulation des Wärmefeldes vorzunehmen, kann als technisches Merkmale betrachtet werden, da eine direkte physische Wirkung des thermischen Sensors, beispielsweise die Zuführung eines Steuersignals für ein Heizelement oder die Erfassung einer Temperaturänderung durch die Sensorkomponente, genutzt wird. Funktionsbeschreibungen des Computercodes und/oder der Software können daher als bevorzugte und definierende Ausführungsformen der Erfindung angesehen werden.

In einem weiteren Aspekt betrifft die Erfindung ein System umfassend
a) ein Sensorpackage nach dem obig Beschriebenen oder eine Sensorpackageanordnung nach dem obig Beschriebenen sowie
b) einen fluidischen Anschluss,
wobei der fluidische Anschluss eine Verbindung mit einem Hauptkanal ermöglicht, sodass das Fluid aus dem Hauptkanal über den Eintrittsbereich in das Sensorpackage und über den Austrittsbereich aus dem Sensorpackage zurück in den Hauptkanal strömen kann.

Ein fluidischer Anschluss bezeichnet eine Verbindungskomponente, durch die ein Fluid fließen kann. Im erfindungsgemäßen Kontext ermöglicht die fluidische Anschlussverbindung insbesondere einen Übergang des Fluides von einem Hauptkanal in das Sensorpackage. Der Übergang meint insbesondere einen Eintritt des Fluides vom Hauptkanal in das Sensorpackage oder in die Sensorpackageanordnung und einen Austritt des Fluides vom Sensorpackage oder von der Sensorpackageanordnung zurück in Hauptkanal. Mithin gibt der fludische Anschluss einen Strömungspfad für das Fluid zwischen dem Hauptkanal und dem Sensorpackage oder der Sensorpackageanordnung vor.

Hierdurch kann vorteilhaft eine Optimierung des Strömungsweges zwischen einem Hauptkanal und dem Bereich des Systems erzielt werden, in dem die Messung des mindestens einen Strömungsparameters vorgenommen werden soll. Insbesondere kann eine Verringerung oder Vermeidung von möglichen Turbulenzen der Strömung erzielt werden, sodass eine zielgerichtete, sensitive und damit auch zuverlässige Messung ausgeführt werden kann.

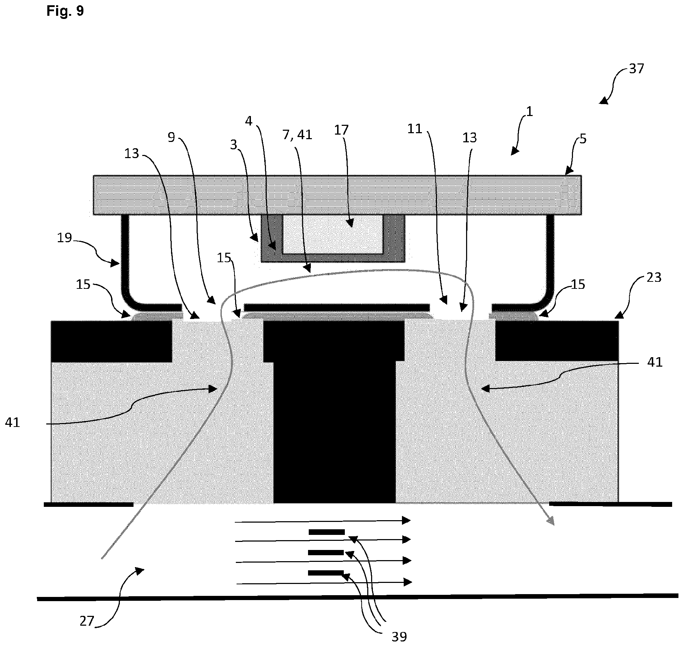

In einer weiteren bevorzugten Ausführungsform ist das System dadurch gekennzeichnet, dass der fluidische Anschluss mit dem Sensorpackage über die Bodenplatte oder über die Abdeckung verbunden ist, wobei mindestens eine Öffnung zur Bereitstellung eines Eintrittsbereiches oder eines Austrittbereiches des Sensorpackages über das Dichtmaterial mit dem fluidischen Anschlusses verbunden vorliegt (vgl. auch Fig. 8, 9).

Mithin kann vorteilhaft durch das Dichtmaterial eine hinreichend stabile Verbindung zwischen dem fluidischen Anschluss und dem Sensorpackage erzielt werden.

Es kann beispielsweise bevorzugt sein, dass das Sensorpackage umfassend einen Sensorchip und eine Bodenplatte mit einer Hauptplatine verbunden ist. Die Hauptplatine kann an der Bodenplatte oder der Abdeckung angebracht sein. Die Hauptplatine weist bevorzugt Hauptplatinenöffnungen auf. Der fluidische Anschluss kann bevorzugt derart mit der Hauptplatine verbunden sein, dass ein Übergang des Fluides vom Hauptkanal durch den fluidischen Anschluss und daraufhin über den Eintrittsbereich in den Strömungskanals des Sensorpackage führt. Daraufhin kann über den Austrittsbereich das Fluid das Sensorpackage über die Hauptplatinenöffnung und den fluidischen Anschluss verlassen und zurück zum Hauptkanal gelangen. Die elektronische Schaltung kann sich bevorzugt auf der Hauptplatine verbinden, welche mit dem Sensorchip, insbesondere dem thermischen Sensor, für eine Ansteuerung des Heizelementes und/oder der Auswertung der Temperaturantwort verbunden ist.

Es kann ebenfalls bevorzugt sein, dass das Sensorpackage direkt mit einem fluidischen Anschluss verbunden ist, ohne dass eine Hauptplatine als eine Zwischenkomponende angebracht ist. Die Verbindung des Sensorpackages mit dem fluidischen Anschluss kann über die Bodenkomponente oder die Abdeckung ermöglicht werden (vgl. auch Fig. 9 für eine direkte Anbringung eines fluidischen Anschlusses an eine Abdeckung des Sensorpackage).

Der fluidische Anschluss umfasst bevorzugt eine Komponente, welche einen Übergang des Fluides in Öffnungen, beispielsweise Öffnungen des Sensorpackages und/oder Hauptplatinenöffnungen zulässt. Der fluidische Anschluss kann bevorzugt einen, zwei oder mehr Anschlussbereiche umfassen, die dazu ausgelegt sind, um an die Öffnungen des Sensorpackages und/oder Hauptplatinenöffnungen verbunden zu werden, um hierdurch insbesondere auch eine Fluidverbindung bereitzustellen. Bevorzugt kann der fluidische Anschluss durch einen oder mehrere Rohrleitungen und/oder Schläuche gebildet werden. Vorzugsweise umfasst der fluidische Anschluss ein Material ausgewählt aus einer Gruppe umfassend Kunststoff, Plastik, Metall und/oder Glas.

In einem weiteren Aspekt betrifft die Erfindung die Verwendung eines Sensorpackages nach dem obig Beschrieben, einer Sensorpackageanordnung nach dem obig Beschriebenen oder eines Systems nach dem obig Beschriebenen zur Messung eines Strömungsparameters eines Fluides in einem Hauptkanal in einer Bypass-Konfiguration.

Der durchschnittliche Fachmann erkennt, dass Erläuterungen, technische Merkmale, Definitionen und Vorteile des Sensopackages, der Sensorpackageanordnung und/oder des Systems des obig Beschrieben sowie von bevorzugten Ausführungsformen der Vorgenannten auch für die Verwendung in eine Bypass-Konfiguration gelten, und umgekehrt.

Eine Bypass-Konfiguration bezeichnet bevorzugt die Anbringung eines Seitenkanals (oder Bypass) zu einem Hauptkanal, in welchem das zu vermessende Fluid hineinströmen kann. Im erfindungsgemäßen Kontext bildet der Strömungskanals des Sensorpackages den Bypass oder einen Teilabschnitt davon. Ein Hauptkanal in Kombination mit einem erfindungsgemäßen Sensorpackage oder einer erfindungsgemäßen Sensorpackageanordnung, deren Strömungskanal den Bypass oder einen Teilabschnitt davon bildet wird erfindungsgemäßen Kontext auch als Bypass-Konfiguration bezeichnet.

Bei einer Bypass-Konfiguration strömt das zu detektierende bzw. das auszumessende Fluid innerhalb des Hauptkanals. Der Bypass ist mit dem Hauptkanal fluidisch verbunden, sodass eine Einleitung des Fluides vom Hauptkanal in den Bypass und eine Rückführung des Fluides vom Bypass zurück in den Hauptkanal ermöglicht werden kann. Ferner liegt bevorzugt bei einer Bypass-Konfiguration ein Durchflussbegrenzer innerhalb des Hauptkanals vor.

Bevorzugt liegt in dem Hauptkanal ein Durchflussbegrenzer eingebracht vor und eine fluidische Verbindung zwischen dem Sensorpackage und dem Hauptkanal wird derart bereitgestellt, dass der Eintrittsbereich des Sensorpackages an einen Bereich des Hauptkanals stromaufwärts des Durchflussbegrenzers angrenzt, während der Austrittsbereich des Sensorpackages an einen Bereich des Hauptkanals stromabwärts des Durchflussbegrenzers angrenzt, sodass eine Druckdifferenz über den Durchflussbegrenzer anhand einer Strömung des Fluides durch den Strömungskanals des Sensorpackages messbar ist.

Der Durchflussbegrenzer bewirkt, dass ein Druckabfall, sodass ein Druckunterschied, insbesondere zwischen einem Bereich des Hauptkanals am Eintrittsbereich des Sensorchips (stromaufwärts des Durchflussbegrenzers) und an einem Bereich des Hauptkanals am Austrittsbereich des Sensorchips (stromabwärts des Durchflussbegrenzers). Durch den Druckunterschied gelangt das Fluid in Bypass gelangen, wobei die Höhe des Druckunterschiedes eine Fließgeschwindigkeit durch den Bypass vorgibt. Dabei strömt das Fluid vom Hauptkanal in den Bypass und vom Bypass in den Hauptkanal zurück.

Durch den Durchflussbegrenzer wird innerhalb des Hauptkanals ein Strömungswiderstand erhöht, wodurch ein Druckunterschied resultiert. Dies kann, ohne auf die Theorie beschränkt zu sein, sich durch zwei Effekte ergeben. Einerseits führt die Reibung zwischen dem Fluid und den Oberflächen des Durchflussbegrenzers (Oberflächen parallel zur Strömung) zu einem Druckabfall, der im Wesentlichen linear mit der Strömung zunimmt. Andererseits erzeugen die Endflächen und ihre Kanten Turbulenzen und damit einen Druckabfall, der im Wesentlichen quadratisch mit der Strömung zunimmt. Eine Druck-/Durchflusskennlinie umfasst daher bevorzugt eine Kombination aus linearen und quadratischen Komponenten.

Ein Durchflussbegrenzer kann bevorzugt ausgewählt sein aus einer Gruppe umfassend eine Messblende (Strömungsblende) und/oder eine Venturi-Düse. Es kann ebenfalls bevorzugt sein, dass der Durchflussbegrenzer eine Wabenstruktur oder eine Schaufelstruktur umfasst. Bevorzugt umfasst der Durchflussbegrenzer eine möglichst hohe Fläche, die parallel zur Strömungsrichtung innerhalb des Hauptkanals gerichtet ist, und eine möglichst geringen Querschnitt dazu.

Durch den Bypass wird insbesondere eine fluidische Verbindung zwischen Sensorpackage und Hauptkanal derart bereitgestellt wird, dass der Eintrittsbereich des Sensorpackage an einen Bereich des Hauptkanals stromaufwärts des Durchflussbegrenzers angrenzt. Der der Austrittsbereich des Sensorpackage grenzt wiederrum an einen Bereich des Hauptkanals an, der stromabwärts des Durchflussbegrenzers angrenzt. Stromaufwärts und Stromabwärts sind hierbei bevorzugt in Bezug auf die Richtung der Fluidströmung im Hauptkanal bezogen. Eine Positionierung des Eintrittsbereich stromaufwärts meint, dass der Eintrittsbereich sich in Richtung der Fluidströmung vor dem Durchflussbegrenzers befindet, während sich der Austrittsbereich in Richtung der Fluidströmung im Hauptkanal hinter dem Durchflussbegrenzers. Die Druckdifferenz über bzw. entlang des Durchflussbegrenzers im Hauptkanal ist somit durch den Sensorchip innerhalb des Bypass messbar.

Vom Hauptkanal gelangt das Fluid in den Bypass. Dies ergibt sich insbesondere dadurch, dass im Bereich des Eintrittsbereich am Hauptkanal ein höher Druck vorliegt als im Bereich des Austrittsbereiches. Dieser Druckunterschied resultiert durch den Durchflussbegrenzer im Hauptkanal und ist abhängig vom Fließverhalten des Fluides im Hauptkanal, wie beispielsweise der Strömungsgeschwindigkeit.

Innerhalb des Bypass kann durch das Sensorpackage, insbesondere durch den thermische Sensor, der Einfluss des Fluides auf das Wärmefeld über die Temperaturantwort erkannt werden. Dabei kann beispielsweise das Strömungsverhalten innerhalb des Strömungskanals des Fluides festgestellt werden.

Die Temperaturantwort ist beispielsweise sensitiv gegenüber der Strömungsgeschwindigkeit im Strömungskanal sein. Da die Strömungsgeschwindigkeit im Bypass unmittelbar mit der strömungsabhängigen Druckdifferenz im Hauptkanal zusammenhängt, erlaubt dies einen Aufschluss über die Strömung im Hauptkanal. Ebenfalls können durch den thermischen Sensor weitere Eigenschaften bzw. Strömungsparameter des Fluides wie beispielsweise einer Wärmekapazität und/oder Wärmleitfähigkeit erhalten werden. Hierdurch wird somit nicht nur eine Überwachung des Strömungsverhaltens des Fluides des Hauptkanals, sondern auch dessen Zusammensetzung ermöglicht.

Die erfindungsgemäßen Aspekte sollen im Folgenden anhand von Figuren beispielhaft beschrieben werden, ohne auf diese Beschreibungen beschränkt zu sein.

### Figuren

### Kurzbeschreibung der Figuren

- **Fig. 1 - 6**: Schematische Darstellung von bevorzugten Ausführungsformen des Sensorpackages.
- **Fig. 7**: Schematische Darstellung einer bevorzugten Ausführungsformen der Strömungssensoranordnung.
- **Fig. 8-9**: Schematische Darstellung von bevorzugten Ausführungsform eines erfindungsgemäßen Systems.

### Detaillierte Beschreibung der Figuren

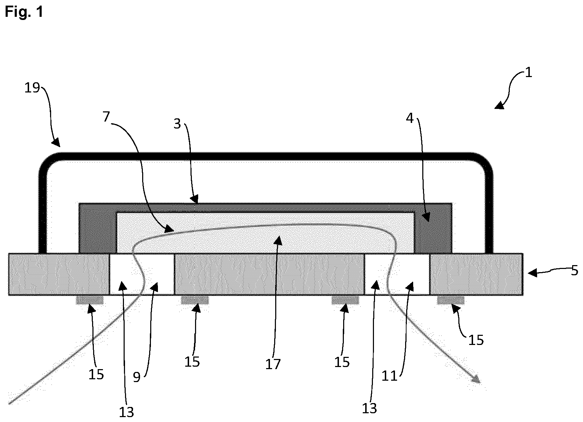

Fig. 1 zeigt eine bevorzugte Ausführungsform des Sensorpackages **1.** Das Sensorpackage **1** umfasst einen Sensorchip **3** zur Messung mindestens eines Strömungsparameters eines Fluides eine Bodenplatte **5** und eine Abdeckung **19.**

Zu diesem Zweck liegt ein Sensorchip **3** mit einem thermischen Sensor (nicht gezeigt) auf einer Bodenplatte **5** vor, welche von einer Abdeckung **7** in Form einer Kappe abgeschlossen wird.

Innerhalb des Sensorchips **3** wird ein Strömungskanal **7** gebildet. Der thermischen Sensor umfasst ein Heizelement zur Bereitstellung eines Wärmefeldes und eine Sensorkomponente zur Erfassung einer Temperaturantwort des thermischen Sensors in Abhängigkeit eines Einflusses des im Strömungskanal **7** strömenden Fluides auf das Wärmefeld.

Vorzugsweise kann der thermische Sensor auf einer Membran positioniert vorliegen, welche von einer Trägerstruktur aus einem Substrat **4** gehalten wird. Unterhalb der Membran mit dem thermischen Sensor befindet sich eine Kavität **17**, wobei der Strömungskanal **7** mindestens teilweise innerhalb der Kavität **17** unter dem thermischen Sensor verläuft.

Zur Ein- und Ausleitung eines zu vermessenden Fluides umfasst das Sensorpackage **1** Öffnungen **13**, die in der gezeigten Ausführungsform in der Bodenplatte **5** eingebracht sind. Eine der Öffnung **13** dient der Bereitstellung eines Eintrittsbereiches **9** und die andere Öffnung dient der Bereitstellung eines Austrittsbereiches **11.** Ein- und Austrittsbereiche **9** und **11** korrespondieren mit dem Abschnitt des Sensorkanals **7**, welcher innerhalb des Substrates **4** des Sensorchips **3** verläuft.

Auf einer Außenseite des Sensorpackages **1** werden die Öffnungen lateral von einem Dichtmaterial **15** umschlossen.

Vorteilhafterweise wird durch das Dichtmaterial **15** eine stabile und fluiddichte Befestigung erreicht, wobei durch das Dichtmaterial **15** eine Verbindung zwischen dem Sensorpackage 1, insbesondere dem Sensorchip **3** und einer Anwendung, z. B. einer Hauptplatine und/oder einem fluidischen Anschluss ermöglicht werden kann. Insbesondere lässt sich das Dichtmaterial **15** mit einfachen und im Stand der Technik bewährten Methoden anbringen, sodass es für einen Fachmann keinen hohen Aufwand bedarf, das Sensorpackage **1** bereitzustellen. Weiterhin wird vorteilhaft eine erhebliche Kostenersparnis durch das erfindungsgemäße Sensorpackage **1** erzielt.

Vorteilhaft ist hierbei zudem der Umstand, dass das Dichtmaterial **15** mehrere Funktionen erfüllen kann. So kann beispielsweise neben einer mechanischen Fixierung und einem fluidischen Abschluss insbesondere zudem eine elektrische Kontaktierungsmöglichkeit geboten werden, indem für das Dichtmaterial **15** ein elektrisch leitfähiges Material gewählt wird. Mithin ermöglicht das Dichtmaterial **15** nicht nur eine einfache, mechanische stabile und fluiddichte Verbindung an eine Hauptströmungskanal, dessen Fluid auszumessen ist, sondern kann gleichzeitig eine elektrische Anbindung der im Sensorpackage **1** enthaltenen elektronischen Komponenten, wie einem thermischen Sensor **3** und/oder eine elektronische Schaltung mit einem externen Schaltungsträger, beispielsweise eine Hauptplatine, gewährleisten.

Weiterhin kann durch das Dichtmaterial **15**, insbesondere sofern eine elastisches Material umfasst, zusätzlich auch eine Federung bewirkt werden. Insbesondere bei starken Strömungen des Fluides kann dies von Vorteil sein, um eine Dämpfung zu erzielen.

Auf dem Gebiet der MEMS-Mikrofone ist es bekannt, einen Lötring für eine sogenannte Bottom-Port Konfiguration für MEMS-Mikrofone auf einer Leiterplatte zu befestigen. Der Lötring kann einen Bereich umschließen, der an der Schalleintrittsöffnung für MEMS-Mikrofone angebracht ist und soll insbesondere für einen akustischen Abschluss dienen. Erfindungsgemäß wurde erkannt, dass ein zumindest in Teilen ähnliches Konzept einen vereinfachten Anschluss von Strömungssensoren an die jeweilige Anwendung ermöglicht.

Dies war keineswegs naheliegend, da sich Strömungssensoren und MEMS-Mikrofone in ihrem Verwendungszweck und ihrem strukturellen Aufbau unterscheiden und der Lötring der MEMS-Mikrofone insbesondere einem akustischen Abschluss dient. Die Anbringung eines Dichtmaterials, welches lateral und außenseitig eine Öffnung, eines Sensorpackages zur thermischen Messung von Strömungen vorsieht, stellt für das technologische Gebiet der Strömungssensoren hingegen eine Abkehr von bekannten Ansätzen und wesentliche Vereinfachung eines Packaging dar.

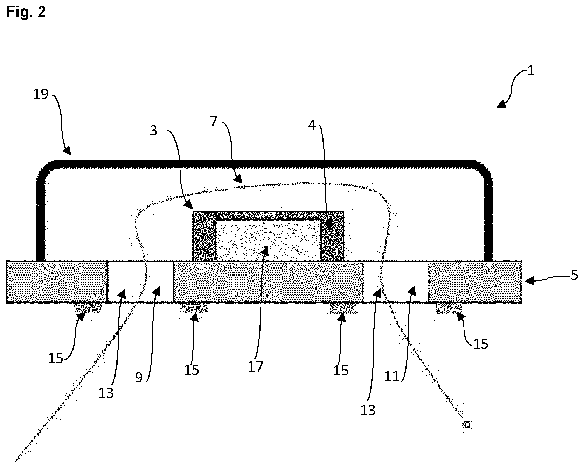

Fig. 2 - 4 zeigen weitere bevorzugte Ausführungsformen des Sensorpackages **1.** Das Sensorpackage **1** umfasst jeweils einen Sensorchip **3** und eine Bodenplatte **5** sowie eine Abdeckung **19.** Innerhalb des Sensorpackages **1** wird der Strömungskanal **7** gebildet. Der Strömungskanal **7** verläuft in den Ausführungsformen jeweils vom Eintrittsbereich **9** bis zum Austrittsbereich **11** außerhalb des Sensorchips **3**, welcher insbesondere einen thermischen Sensor (nicht gezeigt) auf einer Membran oberhalb einer Kavität **17** umfassen kann.

In der Ausführungsform gemäß Fig. 2 werden die Öffnungen **13** zur Bereitstellung des Eintrittsbereiches **9** und des Austrittsbereiches **11** jeweils in der Bodenplatte **5** eingebracht. Das Dichtmaterial **15** umschließt auf der Außenseite des Sensorpackages (bzw. hier einer Außenseite der Bodenplatte **5**) lateral die Öffnungen **13.**

In der Ausführungsform gemäß Fig. 3 wird die Öffnung **13** zur Bereitstellung eines Eintrittsbereiches **9** in die Bodenplatte **5** angebracht. Die Öffnung **13** zur Bereitstellung eines Austrittsbereiches **11** liegt in der Abdeckung **19** eingebracht vor. Das Dichtmaterial **15** umschließt auf der Außenseite des Sensorpackages, insbesondere auf einer Außenseite der Bodenplatte **5** und der Abdeckung **19**, lateral die Öffnungen **13.**

In der Ausführungsform gemäß Fig. 4 sind die Öffnungen **13** zur Bereitstellung des Eintrittsbereiches **9** und des Austrittsbereiches **11** in die Abdeckung **19** eingebracht. Das Dichtmaterial **15** umschließt auf einer Außenseite des Sensorpackages (bzw. hier einer Außenseite der Abdeckung **19**) lateral die Öffnungen **13.**

Fig. 5 zeigt eine weitere bevorzugte Ausführungsform des Sensorpackages **1.** Das Sensorpackage **1** umfasst einen Sensorchip **3**, eine Bodenplatte **5** und eine Abdeckung **19.** Analog zur Ausführungsform der Fig. 3 ist eine Öffnung **13** zur Bereitstellung eines Eintrittsbereiches **9** in der Bodenplatte **5** eingebracht, während eine Öffnung **13** zur Bereitstellung eines Austrittsbereiches **11** in der Abdeckung **19** eingebracht. Das Dichtmaterial **15** umschließt jeweils auf einer Außenseite des Sensorpackages lateral die Öffnungen **13** an der Abdeckung **19** und der Bodenplatte **5.**

Abweichend von der Ausführungsform der Fig. 3 verläuft der Strömungskanal **7** jedoch zumindest teilweise durch den Sensorchip **3**, insbesondere durch eine Kavität **17** oberhalb deren sich einen thermischen Sensor (nicht gezeigt) auf einer Membran befindet.

Zu diesem Zweck befindet sich der Eintrittsbereich **9** unmittelbar unterhalb der Kavität **17** und eine Apertur **29** im Sensorchip **3** bildet einen Abschnitt des Strömungskanals **7.** Die Apertur **29** kann beispielsweise durch eine Öffnung in der Membran gebildet werden, auf welcher sich der thermische Sensor befindet. Der thermische Sensor umfasst bevorzugt ein Heizelement und einen Temperatursensor, welcher in hinreichender Nähe zur Apertur **29** angebracht vorliegt, vorzugsweise derart, dass die Apertur **29** sich zwischen dem Heizelement und dem Temperatursensor befindet. Hierdurch kann ein besonders starker Einfluss des Fluides auf das vom Heizelement bereitgestellte Wärmefeld genutzt werden, um eine sensitive Messung auszuführen.

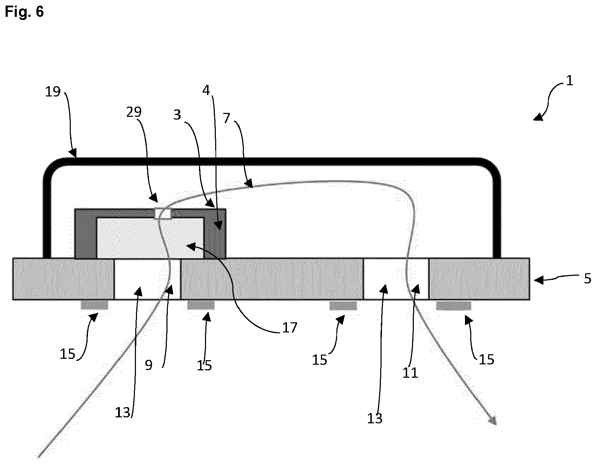

Fig. 6 zeigt eine weitere bevorzugte Ausführungsform des Sensorpackages **1.** Das Sensorpackage **1** umfasst den Sensorchip **3** und die Bodenplatte **5** sowie eine Abdeckung **19.**

Analog zur Ausführungsform der Fig. 5 verläuft der Strömungskanal **7** zumindest teilweise durch den Sensorchip **3,** insbesondere durch eine Kavität **17** oberhalb derer sich ein thermischen Sensor (nicht gezeigt) auf einer Membran befindet. Zu diesem Zweck befindet sich der Eintrittsbereich **9** wiederum unterhalb der Kavität **17** und eine Apertur **29** im Sensorchip **3** bildet einen Abschnitt des Strömungskanals **7.** Die Apertur **29** kann beispielsweise durch eine Öffnung in der Membran gebildet werden, auf welcher sich der thermische Sensor befindet.

Abweichend von der Ausführungsform der Fig. 6 befindet sich der Austrittsbereich **11** nicht in der Abdeckung **19**, sondern in der Bodenplatte **5.**

Fig. 7 zeigt eine bevorzugte Ausführungsform einer Sensorpackageanordnung **21.** Die Sensorpackageanordnung **21** umfasst ein Sensorpackage **1** und eine Hauptplatine **25.** Das Sensorpackage **1** liegt auf der Hauptplatine **25** installiert vor. Ferner weist die Hauptplatine **25** Hauptplatinenöffnungen **25** auf. Die Öffnungen **13** zur Bereitstellung eines Eintrittsbereiches **9** und eines Austrittbereiches **11** des Sensorpackages **1** liegen über das Dichtmaterial **15** mit den Hauptplatinenöffnungen **33** verbunden vor. Vorzugsweise ist das Dichtmaterial **15** als Lötring ausgestaltet, sodass diese neben einem fluidischen Abschluss gleichzeitig einer elektrischen Kontaktierung dienen kann.

Die Sensorpackageanordnung **21** weist ferner eine elektronische Schaltung **31** auf, die dazu konfiguriert ist, den mindestens einen Strömungsparameter auf Basis einer Messung durch die Sensorkomponente zu bestimmen. Die elektronische Schaltung **31** liegt auf der Hauptplatine **25** angebracht vor. Vorteilhaft kann durch Bereitstellung des Lötrings **15** das Sensorpackage **1** als ein SMD-Bauteil bereitgestellt werden, sodass eine direkte Verbindung des Sensorpackages **1** an die Hauptplatine **25** mittels Oberflächenmontage ermöglicht werden. Vorteilhaft ist es nicht notwendig, beispielsweise Drahtverbindungen etc. zu implementieren, sodass eine kompaktere Aufbringung ermöglicht wird.

Fig. 8 zeigt eine bevorzugte Ausführungsform eines Systems **37.** Das System **37** umfasst eine Sensorpackageanordnung **21** umfassend ein Sensorpackage **1**, welches auf einer Hauptplatine **25** installiert ist sowie einen fluidischen Anschluss **23.** Der fluidische Anschluss **23** ermöglicht eine Verbindung mit einem Hauptkanal **27**, sodass das Fluid aus dem Hauptkanal **27** über den Eintrittsbereich **9** in das Sensorpackage **1** und über den Austrittsbereich **11** aus dem Sensorpackage **1** zurück in den Hauptkanal **27** strömen kann. Der fluidische Anschluss **23** ist zu diesem Zweck mit dem Sensorpackage **1** über die Hauptplatine **25** bzw. deren Hauptplatinenöffnungen **33** verbunden. Die Öffnungen **13** zur Bereitstellung des Eintrittsbereiches **9** oder des Austrittbereiches **11** des Sensorpackages **13** liegen wiederum über das Dichtmaterial **15**, vorzugsweise als Lötring, mit der Hauptplatine **25** verbunden vor.

Das System **37** wird in einer Bypass-Konfiguration eingesetzt, bei welcher der Strömungskanal **7** des Sensorpackages **1** den Bypass **41** bzw. einen Teilabschnitt davon bildet.

Dazu wird ein Durchflussbegrenzer **39** in dem Hauptkanal **27** eingebracht vor. Eine fluidische Verbindung zwischen dem Sensorpackage **1** und dem Hauptkanal **27** wird derart bereitgestellt, dass der Eintrittsbereich **9** des Sensorpackages **1** an einen Bereich des Hauptkanals **27** stromaufwärts des Durchflussbegrenzers **39** angrenzt, während der Austrittsbereich des Sensorpackages **11** an einen Bereich des Hauptkanals **27** stromabwärts des Durchflussbegrenzers **39** angrenzt.

Der Durchflussbegrenzer **39** bewirkt, dass ein Druckabfall, insbesondere ein Druckunterschied vorliegt, insbesondere in einem Bereich des Hauptkanals **27** am Eintrittsbereich **9** und an einem Bereich des Hauptkanals **27** am Austrittsbereich **11.** Durch den Druckunterschied kann das Fluid in den Bypass **41** gelangen. Dabei strömt das Fluid vom Hauptkanal **27** in den Bypass **41** und vom Bypass **41** in den Hauptkanal **27** zurück.

Innerhalb des Bypass **41** kann durch das Sensorpackage **1**, insbesondere durch den thermischen Sensor, der Einfluss des Fluides auf das Wärmefeld über die Temperaturantwort erkannt werden. Dabei kann beispielsweise das Strömungsverhalten innerhalb des Strömungskanals des Fluides festgestellt werden. Da die Strömungsgeschwindigkeit im Bypass **41** unmittelbar mit der strömungsabhängigen Druckdifferenz im Hauptkanal **41** zusammenhängt, erlaubt dies einen Aufschluss über die Strömung im Hauptkanal **27.**

Fig. 9 zeigt analog zur Fig. 8 eine weitere bevorzugte Ausführungsform eines Systems **37** in einer Bypass-Konfiguration. Das System **37** umfasst ein Sensorpackage **1** und einen fluidischen Anschluss **23** für die Anbindung an einen Hauptkanal **27.** Abweichend von der Ausführungsform der Fig. 8 liegt das Sensorpackage **1** nicht auf einer Hauptplatine vor. Stattdessen ist der fluidische Anschluss **23** über Öffnungen **13** mit der Abdeckung **19** des Sensorpackages verbunden. Die Öffnungen **13** in der Abdeckung zur Bereitstellung des Eintrittsbereiches **9** oder des Austrittbereiches **11** des Sensorpackages **13** sind dabei vom Dichtmaterial **15** lateral umschlossen, um eine stabile und fluiddichte Verbindung mit dem fluidischen Anschluss **23** zu gewährleisten.

### Bezugszeichenliste

- 1: Sensorpackage
- 3: Sensorchip
- 4: Substrat
- 5: Bodenplatte
- 7: Strömungskanal
- 9: Eintrittsbereich
- 11: Austrittsbereich
- 13: Öffnung
- 15: Dichtmaterial, Lotmaterial
- 17: Kavität
- 19: Abdeckung
- 21: Sensorpackageanordnung
- 23: Fluidischer Anschluss
- 25: Hauptplatine
- 27: Hauptkanal
- 29: Apertur
- 31: Elektronische Schaltung
- 33: Hauptplatinenöffnung
- 37: System
- 39: Durchflussbegrenzer
- 41: Bypass

### Literaturverzeichnis

Kuo, Jonathan TW, Lawrence Yu, and Ellis Meng. "Micromachined thermal flow sensors -A review." Micromachines 3.3 (2012): 550-573.
Palmer, Kristoffer, et al. "A highly integratable silicon thermal gas flow sensor." Journal of Micromechanics and Microengineering 22.6 (2012): 065015.
Lee, Y. C., Ramesh Ramadoss, and Nils Hoivik. "Introduction to MEMS packaging." Mems Packaging 5 (2018): 1.

## Patentansprüche

1. Sensorpackage (1) umfassend einen Sensorchip (3) zur Messung mindestens eines Strömungsparameters eines Fluides, eine Bodenplatte (5) und eine Abdeckung (19), wobei das Sensorpackage (1) an der Abdeckung (19) und/oder der Bodenplatte (5) Öffnungen (13) zur Bereitstellung eines Eintrittsbereiches (9) und eines Austrittbereiches (11) für das Fluid aufweist, sodass innerhalb des Sensorpackages (1) ein Strömungskanal (7) gebildet wird und wobei ferner der Sensorchip (3) einen thermischen Sensor aufweist, umfassend ein Heizelement zur Bereitstellung eines Wärmefeldes und eine Sensorkomponente zur Erfassung einer Temperaturantwort des thermischen Sensors in Abhängigkeit eines Einflusses des im Strömungskanal (7) strömenden Fluides auf das Wärmefeld,
**dadurch gekennzeichnet, dass**
mindestens eine Öffnung (13) auf einer Außenseite des Sensorpackages (1) lateral von einem Dichtmaterial (15) umschlossen wird.

2. Sensorpackage (1) nach dem vorherigen Anspruch
**dadurch gekennzeichnet, dass**
das Dichtmaterial (15) ringförmig die mindestens eine Öffnung (13) lateral umschließt und einen Dichtring bildet.

3. Sensorpackage (1) nach einem oder mehreren der vorherigen Ansprüche
**dadurch gekennzeichnet, dass**
das Dichtmaterial (15) ein Lotmaterial, ein Bondmaterial, einen Klebstoff und/oder einen Kunststoff, vorzugsweise ein Elastomer umfasst.

4. Sensorpackage (1) nach einem oder mehreren der vorherigen Ansprüche
**dadurch gekennzeichnet, dass**
das Dichtmaterial (15) ein Lotmaterial umfasst, welches als Lötring vorliegt, wobei bevorzugt das Lotmaterial ein Material umfasst, ausgewählt aus einer Gruppe umfassend, Zinn, Zink, Kupfer, Silber, Gold, deren Verbindungen und/oder Legierungen.

5. Sensorpackage (1) nach einem oder mehreren der vorherigen Ansprüche
**dadurch gekennzeichnet, dass**
durch das Dichtmaterial (15) eine elektrische Verbindung vorliegt, die für eine elektrischen Anschluss verwendbar ist.

6. Sensorpackage (1) nach einem oder mehreren der vorherigen Ansprüche
**dadurch gekennzeichnet, dass**
die Bodenplatte (5) als ein Halbleitersubstrat oder als ein Schaltungsträger, vorzugsweise als eine Leiterplatte vorliegt.

7. Sensorpackage (1) nach einem oder mehreren der vorherigen Ansprüche
**dadurch gekennzeichnet, dass**
die Abdeckung (19) als eine Kappe oder als ein Deckelsubstrat vorliegt,
wobei bevorzugt die Abdeckung (19) ein Material umfasst ausgewählt aus einer Gruppe umfassend ein Dielektrikum, einen Halbleiter, einen Leiter und/oder Kombinationen davon,
wobei bevorzugt das Dielektrikum ausgewählt ist aus einer Gruppe umfassend Siliziumnitrid, Siliziumdioxid, Aluminiumoxid, Aluminiumnitrid, Polyimid und/oder ein polymeres Material,
wobei bevorzugt der Halbleiter ausgewählt ist aus einer Gruppe umfassend Monosilizium, Polysilizium, Germanium und/oder Chalkogenid und/oder
wobei bevorzugt der Leiter ausgewählt ist aus einer Gruppe umfassend Aluminium, Titan Zink und/oder ein Edelmetall, vorzugsweise ausgewählt aus einer Gruppe umfassend bevorzugt Gold, Platin, Iridium, Palladium, Osmium, Silber, Rhodium und/oder Ruthenium.

8. Sensorpackage (1) nach einem oder mehreren der vorherigen Ansprüche
**dadurch gekennzeichnet, dass**
die Sensorkomponente durch einen Temperatursensor gebildet wird,
wobei bevorzugt der Temperatursensor ausgewählt ist aus einer Gruppe umfassend ein Thermoelement, eine Diode, ein Thermistor und/oder eine Thermosäule und/oder das Heizelement ein elektrisches Heizelement ist, bevorzugt ein Heizwiderstand ist, wobei vorzugsweise der thermische Sensor zwei Temperatursensoren umfasst.

9. Sensorpackage (1) nach einem oder mehreren der vorherigen Ansprüche
**dadurch gekennzeichnet, dass**
der Sensorchip (3) eine Membran aufweist, auf welcher der thermische Sensor positioniert ist,
wobei bevorzugt die Membran ein elektrisches leitfähiges Material und/oder ein dielektrisches Material umfasst,
wobei bevorzugt das elektrisch leitfähige Material ausgewählt ist aus einer Gruppe umfassend Halbleiter und/oder Metalle, insbesondere Silizium, Polysilizium, Graphen, Chalkogenid, und/oder
wobei bevorzugt das dielektrische Material ausgewählt ist aus einer Gruppe umfassend Siliziumnitrid, Siliziumdioxid, Aluminiumoxid, Aluminiumnitrid, Polyimid und/oder ein polymeres Material.

10. Sensorpackage (1) nach einem oder mehreren der vorherigen Ansprüche
**dadurch gekennzeichnet, dass**
der Sensorchip (3) eine Kavität (17) aufweist, oberhalb derer sich eine Membran erstreckt, auf welcher der thermische Sensor positioniert ist, wobei bevorzugt der Sensorchip eine Apertur (29) aufweist, welche vorzugsweise an der Membran angebracht ist, wobei ferner die Apertur (29) als ein Abschnitt des Strömungskanals (7) vorliegt oder der Strömungskanal (7) zumindest teilweise innerhalb der Kavität (17) verläuft.

11. Sensorpackage (1) nach einem oder mehreren der vorherigen Ansprüche
**dadurch gekennzeichnet, dass**
der Strömungskanal (7) innerhalb des Sensorpackages (1) verläuft und der Eintrittsbereich (9) und der Austrittbereich (11) des Strömungskanals (7) durch Öffnungen (13) an der Bodenplatte (5) und/oder der Abdeckung (19) vorliegen.

12. Sensorpackage (1) nach einem oder mehreren der vorherigen Ansprüche
**dadurch gekennzeichnet, dass**
der Sensorchip (3) ein Substrat (4) aufweist, wobei der thermische Sensor auf einer Vorderseite des Substrates (4) positioniert vorliegt und mindestens ein Abschnitt des Strömungskanals (7) unterhalb des thermischen Sensors innerhalb des Substrates (4) gebildet wird, welcher ausgehend von einer Rückseite des Substrates durch bereichsweise Entfernung des Substrates (4) gebildet wurde, wobei das Substrat (4) vorzugsweise monolithisch ausgestaltet ist.

13. Sensorpackageanordnung (21) umfassend
a. ein Sensorpackage (1) nach einem der vorherigen Ansprüche und
b. eine Hauptplatine (25)
**dadurch gekennzeichnet, dass**
das Sensorpackage (1) auf der Hauptplatine (25) installiert vorliegt.

14. System (37) umfassend
a) ein Sensorpackage (1) nach einem oder mehreren der vorherigen Ansprüche 1 - 12 oder eine Sensorpackageanordnung (21) nach Anspruch 13 sowie
b) einen fluidischen Anschluss (23),
wobei der fluidische Anschluss (23) eine Verbindung mit einem Hauptkanal (27) ermöglicht, sodass das Fluid aus dem Hauptkanal (27) über den Eintrittsbereich (9) in das Sensorpackage (1) und über den Austrittsbereich (11) aus dem Sensorpackage (1) zurück in den Hauptkanal (27) strömen kann.

15. Verwendung eines Sensorpackages (1) nach einem oder mehreren der vorherigen Ansprüche 1 - 12, einer Sensorpackageanordnung (21) nach Anspruch 13 oder eines Systems (37) nach Anspruch 14 zur Messung eines Strömungsparameters eines Fluides in einem Hauptkanal (27) in einer Bypass-Konfiguration.
